# EUROPEAN PATENT SPECIFICATION

(11) **EP 1 515 373 B1**
(45) Date of publication and mention of the grant of the patent: **03.11.2010**
(21) Application number: 04255467.5
(22) Date of filing: 09.09.2004
(51) Int. Cl.: H01L 31/075, H01L 31/0368, H01L 31/18, H01L 31/0236

(54) **Photovoltaic apparatus**
Photovoltaische Anordnung
Dispositif photovoltaïque

(30) Priority: 12.09.2003 JP 2003321273
(43) Date of publication of application: 16.03.2005
(73) Proprietor: SANYO ELECTRIC CO., LTD., Moriguchi-shi, Osaka-fu 570-8677 (JP)
(72) Inventor: Shima, Masaki, Uji-shi Kyoto 611-0031 (JP)
(74) Representative: Calderbank, Thomas Roger

(56) References cited:
- US-A1- 2002 050 289
- US-A1- 2003 153 165
- US-B1- 6 172 296
- US-B1- 6 388 301

## Description

### BACKGROUND OF THE INVENTION

### Field of the Invention

The present invention relates to a photovoltaic apparatus, and more particularly, it relates to a photovoltaic apparatus including at least one power generation unit consisting of a plurality of non-single-crystalline semiconductor layers.

### Description of the Background Art

A photovoltaic apparatus employing a microcrystalline silicon semiconductor layer as a photoelectric conversion layer is known in general, as disclosed in US Patent 2002/0008192, for Example. A microcrystalline silicon semiconductor, including a large number of crystal grains having the maximum grain size of not more than several hundred nm and containing Si as a constituent element, also includes that having an amorphous phase therein. The photovoltaic apparatus employing the microcrystalline silicon layer as the photoelectric conversion layer disclosed in the aforementioned US Patent 2002/0008192 can absorb light of a wider range with smaller reduction of conversion efficiency resulting from photodeterioration as compared with a photovoltaic apparatus employing an amorphous silicon semiconductor layer as a photoelectric conversion layer.

The photovoltaic apparatus employing the microcrystalline silicon layer as the photoelectric conversion layer disclosed in the aforementioned US Patent 2002/0008192 employs a substrate having an irregular surface with a back electrode, an n-type layer, a photoelectric conversion layer, a p-type layer and a front electrode successively formed thereon. Therefore, the back electrode and the n-type layer have irregular surfaces reflecting the irregular shape of the surface of the substrate, whereby incident light can be scattered through the irregular surfaces of the back electrode and the n-type layer. Thus, an optical confinement effect can be improved.

In the photovoltaic apparatus disclosed in the aforementioned US Patent 2002/0008192, however, the optical confinement effect is disadvantageously still insufficient. More specifically, the absorption coefficient of a microcrystalline silicon semiconductor is lower by one order of magnitude than that of an amorphous silicon semiconductor, and hence the thickness of the photoelectric conversion layer consisting of the microcrystalline silicon semiconductor must be increased in order to attain light absorption similarly to a photoelectric conversion layer consisting of an amorphous silicon semiconductor. When the thickness of the photoelectric conversion layer is increased, however, the irregular surface of the photoelectric conversion layer consisting of the microcrystalline silicon semiconductor is loosened to approach a substantially flat surface despite the irregular surface of the substrate. Therefore, the surfaces of the p-type layer and the front electrode successively formed on the photoelectric conversion layer also approach substantially flat surfaces, and hence it is difficult to scatter the incident light through the surfaces of the p-type layer and the front electrode. In the photovoltaic apparatus disclosed in the aforementioned US Patent 2002/0008192, therefore, it is difficult to improve the optical confinement effect by scattering on the front side. Consequently, it is difficult to more effectively absorb the incident light with the photoelectric conversion layer in the photovoltaic apparatus employing the microcrystalline silicon layer as the photoelectric conversion layer disclosed in the aforementionedUS Patent 2002/0008192, and hence it is disadvantageously difficult to improve the output characteristics.

### SUMMARY OF THE INVENTION

The present invention has been proposed in order to solve the aforementioned problem, and an object of the present invention is to provide a photovoltaic apparatus capable of improving output characteristics.

In order to attain the aforementioned object, a photovoltaic apparatus according to an aspect of the present invention includes at least one power generation unit having a first conductivity type first non-single-crystalline semiconductor layer including at least one layer, a substantially intrinsic second non-single-crystalline semiconductor layer, formed on the first non-single-crystalline semiconductor layer, including at least one layer and functioning as a photoelectric conversion layer and a second conductivity type third non-single-crystalline semiconductor layer, formed on the second non-single-crystalline semiconductor layer, including at least one layer, and at least one of the layer constituting the first non-single-crystalline semiconductor layer, the layer constituting the second non-single-crystalline semiconductor layer and the layer constituting the third non-single crystalline semiconductor layer has a preferred crystal orientation plane different from the preferred crystal orientation planes of the remaining layers.

In the photovoltaic apparatus according to this aspect of the present invention, as hereinabove described, at least one of the layer constituting the first non-single-crystalline semiconductor layer, the layer constituting the second non-single-crystalline semiconductor layer and the layer constituting the third non-single-crystalline semiconductor layer has the preferred crystal orientation different from those of the remaining layers so that the surface of at least one of the layer constituting the first non-single-crystalline semiconductor layer, the layer constituting the second non-single-crystalline semiconductor layer and the layer constituting the third non-single-crystalline semiconductor layer can be irregularized also when the surfaces of the remaining layers are substantially flattened, by forming at least one of the layer constituting the first non-single-crystalline semiconductor layer, the layer constituting the second non-single-crystalline semiconductor layer and the layer constituting the third non-single-crystalline semiconductor layer to have a preferred crystal orientation plane easily providing an irregular surface while forming the surfaces of the remaining layers to have preferred crystal orientation planes easily providing substantially flat surfaces. Thus, incident light can be scattered through the irregular surface of at least one of the layer constituting the first non-single-crystalline semiconductor layer, the layer constituting the second non-single-crystalline semiconductor layer and the layer constituting the third non-single-crystalline semiconductor layer, whereby an excellent optical confinement effect can be attained. Consequently, the layer constituting the second non-single-crystalline semiconductor layer functioning as a photoelectric conversion layer can efficiently absorb the incident light, whereby the output characteristics of the photovoltaic apparatus can be improved.

In the photovoltaic apparatus according to the aforementioned aspect, the layers constituting the first and third non-single-crystalline semiconductor layers respectively and the layer constituting the second non-single crystalline semiconductor layer preferably have preferred crystal orientation planes different from each other. According to this structure, the surface of the layer constituting the third non-single-crystalline semiconductor layer formed on the layer constituting the second non-single-crystalline semiconductor layer as well as the surface of the layer constituting the first non-single-crystalline semiconductor layer formed under the layer constituting the second non-single-crystalline semiconductor layer can be irregularized also when the surface of the layer constituting the second non-single-crystalline semiconductor layer is substantially flattened, by forming the layer constituting the second non-single-crystalline semiconductor layer to have a preferred crystal orientation plane easily providing a substantially flat surface while forming the layers constituting the first and third non-single-crystalline semiconductor layers respectively to have preferred crystal orientation planes easily providing irregular surfaces, for example. Thus, the incident light can be scattered through the irregular surfaces of the layers constituting the first and third non-single-crystalline semiconductor layers respectively, whereby a further excellent optical confinement effect can be attained. When forming the layers constituting the first and third non-single-crystalline semiconductor layers respectively to have preferred crystal orientation planes easily providing substantially flat surfaces while forming the layer constituting the second non-single-crystalline semiconductor layer to have a preferred crystal orientation plane easily providing an irregular surface, on the other hand, the surface of the layer constituting the second non-single-crystalline semiconductor layer formed on the layer constituting the first non-single-crystalline semiconductor layer can be irregularized also when the surface of the layer constituting the first non-single-crystalline semiconductor layer is substantially flattened, whereby the incident light can be scattered through the irregular surface of the layer constituting the second non-single-crystalline semiconductor layer. An excellent optical confinement effect can be attained also in this case.

In the photovoltaic apparatus according to the aforementioned aspect, the first non-single-crystalline semiconductor layer, the second non-single-crystalline semiconductor layer and the third non-single crystalline semiconductor layer preferably include non-single-crystalline silicon layers, and either the layers constituting the first and third non-single-crystalline semiconductor layers respectively or the layer constituting the second non-single crystalline semiconductor layer preferably have (111)-plane preferred crystal orientation and the other one of the layers constituting the first and third non-single-crystalline semiconductor layers respectively and the layer constituting the second non-single crystalline semiconductor layer preferably have (220)-plane preferred crystal orientation. According to this structure, the surface of the layer constituting the third non-single-crystalline semiconductor layer formed on the layer constituting the second non-single-crystalline semiconductor layer as well as the surface of the layer constituting the first non-single-crystalline semiconductor layer formed under the layer constituting the second non-single-crystalline semiconductor layer can be easily irregularized also when the surface of the layer constituting the second non-single-crystalline semiconductor layer is substantially flattened, by forming the layer constituting the second non-single-crystalline semiconductor layer to have (220)-plane preferred crystal orientation while forming the layers constituting the first and third non-single-crystalline semiconductor layers respectively to have (111)-plane preferred crystal orientation, for example, since the surface of a non-single-crystalline silicon layer having (111)-plane preferred crystal orientation is easily irregularized while the surface of a non-single-crystalline silicon layer having (220)-plane preferred crystal orientation is easily substantially flattened. When forming the layers constituting the first and third non-single-crystalline semiconductor layers respectively to have (220)-plane preferred crystal orientation while forming the layer constituting the second non-single-crystalline semiconductor layer to have (111)-plane preferred crystal orientation, on the other hand, the surface of the layer constituting the second non-single-crystalline semiconductor layer formed on the layer constituting the first non-single-crystalline semiconductor layer can be easily irregularized also when the surface of the layer constituting the first non-single-crystalline semiconductor layer is substantially flattened.

In this case, the layer constituting the second non-single crystalline semiconductor layer may have (220)-plane preferred crystal orientation, and the layers constituting the first and third non-single-crystalline semiconductor layers respectively may have (111)-plane preferred crystal orientation. According to this structure, the surfaces of the layers constituting the first and third non-single-crystalline semiconductor layers respectively are so irregularized that the incident light can be scattered through the irregular surfaces of the layers constituting the first and third non-single-crystalline semiconductor layers respectively. Further, the photoelectric conversion layer consisting of the layer constituting the second non-single-crystalline semiconductor layer formed to have (220)-plane preferred crystal orientation has particularly excellent characteristics, whereby the output characteristics of the photovoltaic apparatus can be further improved.

In the aforementioned structure that either the layers constituting the first and third non-single-crystalline semiconductor layers respectively or the layer constituting the second non-single-crystalline semiconductor layer has (111)-plane preferred crystalline orientation while the other one of the layers constituting the first and third non-single-crystalline semiconductor layers respectively and the layer constituting the second non-single-crystalline semiconductor layer has (220)-plane preferred crystal orientation, the layer constituting the second non-single crystalline semiconductor layer may have (111)-plane preferred crystal orientation and the layers constituting the first and third non-single-crystalline semiconductor layers respectively may have (220)-plane preferred crystal orientation. According to this structure, the surface of the layer constituting the second non-single-crystalline semiconductor layer is so irregularized that the incident light can be scattered through the irregular surface of the layer constituting the second non-single-crystalline semiconductor layer.

In the photovoltaic apparatus according to the aforementioned aspect, either the layer constituting the first non-single crystalline semiconductor layer or the layer constituting the third non-single-crystalline semiconductor layer preferably has the same preferred crystal orientation plane as the layer constituting the second non-single-crystalline semiconductor layer, and the other one of the layers constituting the first and third non-single crystalline semiconductor layers respectively preferably has a preferred crystal orientation plane different from the preferred crystal orientation plane of the layer constituting the second non-single-crystalline semiconductor layer. According to this structure, the surface of the other one of the layers constituting the first and third semiconductor layers respectively can be irregularized also when one of the layers constituting the first and third non-single-crystalline semiconductor layers and the layer constituting the second non-single-crystalline semiconductor layer are formed to have preferred crystal orientation planes easily providing substantially flat surfaces, by forming the other one of the layers constituting the first and third non-single-crystalline semiconductor layers respectively to have a preferred crystal orientation plane easily providing an irregular surface. Thus, the incident light can be scattered through the irregular surface of the other one of the layers constituting the first and third non-single-crystalline semiconductor layers respectively, whereby an excellent optical confinement effect can be attained. Also when the other one of the layers constituting the first and third non-single-crystalline semiconductor layers respectively is formed to have a preferred crystal orientation plane easily providing a substantially flat surface, the surfaces of either the layer constituting the first non-single-crystalline semiconductor layer or the layer constituting the third non-single-crystalline semiconductor layer and the layer constituting the second non-single-crystalline semiconductor layer can be irregularized by forming either the layer constituting the first non-single-crystalline semiconductor layer or the layer constituting the third non-single-crystalline semiconductor layer and the layer constituting the second non-single-crystalline semiconductor layer to have preferred crystal orientation planes easily providing irregular surfaces. Thus, the incident light can be scattered through the irregular surfaces of either the layer constituting the first non-single-crystalline semiconductor layer or the layer constituting the third non-single-crystalline semiconductor layer and the layer constituting the second non-single-crystalline semiconductor layer, whereby an excellent optical confinement effect can be attained also in this case.

In this case, the first non-single-crystalline semiconductor layer, the second non-single-crystalline semiconductor layer and the third non-single-crystalline semiconductor layer may include non-single-crystalline silicon layers, and the layer constituting the first non-single-crystalline semiconductor layer may have (111)-plane preferred crystal orientation, while the layers constituting the second and third non-single-crystalline semiconductor layers respectively may have (220)-plane preferred crystal orientation. According to this structure, the surface of the layer constituting the first non-single-crystalline semiconductor layer is irregularized while the surfaces of the layers constituting the second and third non-single-crystalline semiconductor layers respectively are substantially flattened since the surface of a non-single-crystalline silicon layer having (111)-plane preferred crystal orientation is easily irregularized while the surface of a non-single-crystalline silicon layer having (220)-plane preferred crystal orientation is easily substantially flattened. Thus, the incident light can be scattered through the irregular surface of the layer constituting the first non-single-crystalline semiconductor layer. Further, the photoelectric conversion layer consisting of the layer constituting the second non-single-crystalline semiconductor layer formed to have (220)-plane preferred crystal orientation has particularly excellent characteristics, whereby the output characteristics of the photovoltaic apparatus can be further improved.

In the aforementioned structure that either the layer constituting the first non-single-crystalline semiconductor layer or the layer constituting the third non-single-crystalline semiconductor layer has the same preferred crystal orientation plane as the layer constituting the second non-single-crystalline semiconductor layer while the other one of the layers constituting the first and third non-single-crystalline semiconductor layers respectively has the preferred crystal orientation different from that of the layer constituting the second non-single-crystalline semiconductor layer, the first non-single-crystalline semiconductor layer, the second non-single-crystalline semiconductor layer and the third non-single-crystalline semiconductor layer may include non-single-crystalline silicon layers, and the layers constituting the first and second non-single-crystalline semiconductor layers respectively may have (111)-plane preferred crystal orientation, while the layer constituting the third non-single-crystalline semiconductor layer may have (220)-plane preferred crystal orientation. According to this structure, the surfaces of the layers constituting the first and second non-single-crystalline semiconductor layers respectively are irregularized while the surface of the layer constituting the third non-single-crystalline semiconductor layer is substantially flattened since the surface of a non-single-crystalline silicon layer having (111)-plane preferred crystal orientation is easily irregularized while the surface of a non-single-crystalline silicon layer having (220)-plane preferred crystal orientation is easily substantially flattened. Thus, the incident light can be scattered through the irregular surfaces of the surfaces of the layers constituting the first and second non-single-crystalline semiconductor layers respectively.

In the aforementioned structure that either the layer constituting the first non-single-crystalline semiconductor layer or the layer constituting the third non-single-crystalline semiconductor layer has the same preferred crystal orientation plane as the layer constituting the second non-single-crystalline semiconductor layer while the other one of the layers constituting the first and third non-single-crystalline semiconductor layers respectively has the preferred crystal orientation plane different from that of the layer constituting the second non-single-crystalline semiconductor layer, the first non-single-crystalline semiconductor layer, the second non-single-crystalline semiconductor layer and the third non-single-crystalline semiconductor layer may include non-single-crystalline silicon layers, and the layer constituting the first non-single-crystalline semiconductor layer may have (220)-plane preferred crystal orientation while the layers constituting the second and third non-single-crystalline semiconductor layers respectively may have (111)-plane preferred crystal orientation. According to this structure, the surface of the layer constituting the first non-single-crystalline semiconductor layer is substantially flattened while the surfaces of the layers constituting the second and third non-single-crystalline semiconductor layers respectively are irregularized since the surface of a non-single-crystalline silicon layer having (111)-plane preferred crystal orientation is easily irregularized while the surface of a non-single-crystalline silicon layer having (220)-plane preferred crystal orientation is easily substantially flattened. Thus, the incident light can be scattered through the irregular surfaces of the layers constituting the second and third non-single-crystalline semiconductor layers respectively.

In the aforementioned structure that either the layer constituting the first non-single-crystalline semiconductor layer or the layer constituting the third non-single-crystalline semiconductor layer has the same preferred crystal orientation plane as the layer constituting the second non-single-crystalline semiconductor layer while the other one of the layers constituting the first and third non-single-crystalline semiconductor layers respectively has the preferred crystal orientation plane different from that of the layer constituting the second non-single-crystalline semiconductor layer, the first non-single-crystalline semiconductor layer, the second non-single-crystalline semiconductor layer and the third non-single-crystalline semiconductor layer may include non-single-crystalline silicon layers, and the layers constituting the first and second non-single-crystalline semiconductor layers respectively may have (220)-plane preferred crystal orientation while the layer constituting the third non-single-crystalline semiconductor layer may have (111)-plane preferred crystal orientation. According to this structure, the surfaces of the layers constituting the first and second non-single-crystalline semiconductor layers respectively are substantially flattened and the surface of the layer constituting the third non-single-crystalline semiconductor layer is irregularized since the surface of a non-single-crystalline silicon layer having (111)-plane preferred crystal orientation is easily irregularized while the surface of a non-single-crystalline silicon layer having (220)-plane preferred crystal orientation is easily substantially flattened. Thus, the incident light can be scattered through the irregular surface of the layer constituting the third non-single-crystalline semiconductor layer. Further, the photoelectric conversion layer consisting of the layer constituting the second non-single-crystalline semiconductor layer formed to have (220)-plane preferred crystal orientation has particularly excellent characteristics, whereby the output characteristics of the photovoltaic apparatus can be further improved.

In the photovoltaic apparatus according to the aforementioned aspect, at least one of the first non-single-crystalline semiconductor layer, the second non-single-crystalline semiconductor layer and the third non-single-crystalline semiconductor layer preferably includes a plurality of layers, and at least one of the plurality of layers preferably has a preferred crystal orientation plane different from the preferred crystal orientation planes of the remaining layers. According to this structure, the surfaces of the remaining layers can be irregularized also when at least one of the plurality of layers is formed to have a preferred crystal orientation plane easily providing a substantially flat surface, for example, by forming the remaining layers other than at least one of the plurality layers to have preferred crystal orientation planes easily providing irregular surfaces. Thus, the incident light can be scattered through the irregular surfaces of the remaining layers other than at least one of the plurality of layers, whereby an excellent optical confinement effect can be attained. Also when the remaining layers other than at least one of the plurality of layers are formed to have preferred crystal orientation planes easily providing substantially flat surfaces, the surface of at least one of the plurality of layers can be irregularized by forming at least one of the plurality of layers to have a preferred crystal orientation plane easily providing an irregular surface. Thus, the incident light can be scattered through the irregular surface of at least one of the plurality of layers, whereby an excellent optical confinement effect can be attained also in this case.

In this case, the second non-single-crystalline semiconductor layer preferably includes a first layer and a second layer, and the first layer and the second layer preferably have preferred crystal orientation planes different from each other. According to this structure, the surface of the other one of the first and second layers can be irregularized also when one of the first and second layers is formed to have a preferred crystal orientation plane easily providing a substantially irregular surface, for example, by forming the other one of the first and second layers to have a preferred crystal orientation plane easily providing an irregular surface. Thus, the incident light can be scattered through the irregular surface of the other one of the first and second layers, whereby an excellent optical confinement effect can be attained.

In the aforementioned structure that the second non-single-crystalline semiconductor layer includes the first and second layers having different preferred crystal orientation planes, the second non-single-crystalline semiconductor layer preferably includes a non-single-crystalline silicon layer, and the first layer preferably has (111)-plane preferred crystal orientation while the second layer is preferably formed on the first layer and preferably has (220)-plane preferred crystal orientation. According to this structure, the surface of the first layer is irregularized and the surface of the second layer is substantially flattened since the surface of a non-single-crystalline silicon layer having (111)-plane preferred crystal orientation is easily irregularized while the surface of a non-single-crystalline silicon layer having (220)-plane preferred crystal orientation is easily substantially flattened. Thus, the incident light can be scattered through the irregular surface of the first layer. Further, the second layer can be crystal-grown from starting points (nuclei) of fine microcrystalline grains of the first layer by forming the second layer having (220)-plane preferred crystal orientation on the first layer having (111)-plane preferred crystal orientation, whereby the quality of the second layer can be improved. In this case, the quality of the second layer having an excellent photoelectric conversion property due to (220)-plane preferred crystal orientation is so improved that the photoelectric conversion property of the second layer can be further improved. Consequently, efficiency for extracting carriers formed by the second non-single-crystalline semiconductor layer including the second layer functioning as a photoelectric conversion layer can be improved.

In this case, the first non-single-crystalline semiconductor layer and the third non-single-crystalline semiconductor layer preferably include non-single-crystalline silicon layers, and the layer constituting the first non-single-crystalline semiconductor layer preferably has (220)-plane preferred crystal orientation, while the layer constituting the third non-single-crystalline semiconductor layer preferably has (111)-plane preferred crystal orientation. According to this structure, the surface of the layer constituting the first non-single-crystalline semiconductor layer is substantially flattened while the surface of the layer constituting the third non-single-crystalline semiconductor layer is irregularized. Thus, the incident light can be scattered also through the irregular surface of the layer constituting the third non-single-crystalline semiconductor layer.

In the photovoltaic apparatus according to the aforementioned aspect, at least one of the layer constituting the first non-single-crystalline semiconductor layer, the layer constituting the second non-single-crystalline semiconductor layer and the layer constituting the third non-single crystalline semiconductor layer preferably has an irregular surface. According to this structure, the incident light can be scattered through the irregular surface of at least one layer, whereby an excellent optical confinement effect can be attained.

In this case, the layer constituting the first non-single-crystalline semiconductor layer and the layer constituting the third non-single crystalline semiconductor layer may have irregular surfaces. According to this structure, the incident light can be scattered through the irregular surfaces of both of the layers constituting the first and third non-single-crystalline semiconductor layers respectively.

In the aforementioned structure that at least one of the layers constituting the first, second and third non-single-crystalline semiconductor layers respectively has an irregular surface, the layer constituting the first non-single-crystalline semiconductor layer and the layer constituting the second non-single crystalline semiconductor layer may have irregular surfaces. According to this structure, the incident light can be scattered through the irregular surfaces of both of the layers constituting the first and second non-single-crystalline semiconductor layers respectively.

In the aforementioned structure that at least one of the layers constituting the first, second and third non-single-crystalline semiconductor layers respectively has an irregular surface, the layer constituting the second non-single-crystalline semiconductor layer and the layer constituting the third non-single crystalline semiconductor layer may have irregular surfaces. According to this structure, the incident light can be scattered through the irregular surfaces of both of the layers constituting the second and third non-single-crystalline semiconductor layers respectively.

In the aforementioned structure that at least one of the layers constituting the first, second and third non-single-crystalline semiconductor layers respectively has an irregular surface, the layer having the irregular surface preferably includes a non-single-crystalline silicon layer having (111)-plane preferred crystal orientation. According to this structure, a non-single crystalline silicon layer having an irregular surface can be easily formed since the surface of a non-single-crystalline silicon layer having (111)-plane preferred crystal orientation is easily irregularized.

The photovoltaic apparatus according to the aforementioned aspect preferably further comprises an underlayer having an irregular surface, while the first non-single-crystalline semiconductor layer preferably has an irregular surface, and the first non-single-crystalline semiconductor layer having the irregular surface is preferably formed on the underlayer having the irregular surface. According to this structure, the incident light can be scattered through the irregular surfaces of both of the underlayer and the first non-single-crystalline semiconductor layer, whereby a further excellent optical confinement effect can be attained as compared with a case of scattering the incident light only through the irregular surface of the first non-single-crystalline semiconductor layer.

In the photovoltaic apparatus according to the aforementioned aspect, the first non-single-crystalline semiconductor layer, the second non-single-crystalline semiconductor layer and the third non-single-crystalline semiconductor layer preferably include microcrystalline semiconductor layers. According to this structure, the photovoltaic apparatus including the microcrystalline semiconductor layers can attain an excellent optical confinement effect.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a sectional view showing the structure of a photovoltaic apparatus prepared according to Example 1 of the present invention;
Fig. 2 is a graph showing the intensity levels of X-ray diffraction peaks of an n-type layer, a photoelectric conversion layer and a p-type layer of the photovoltaic apparatus according to Example 1 shown in Fig. 1 respectively;
Fig. 3 is a sectional view showing the structure of a photovoltaic apparatus prepared according to Example 2 of the present invention;
Fig. 4 is a graph showing the intensity levels of X-ray diffraction peaks of an n-type layer, a photoelectric conversion layer and a p-type layer of the photovoltaic apparatus according to Example 2 shown in Fig. 3 respectively;
Fig. 5 is a sectional view showing the structure of a photovoltaic apparatus prepared according to Example 3 of the present invention;
Fig. 6 is a graph showing the intensity levels of X-ray diffraction peaks of an n-type layer, a photoelectric conversion layer and a p-type layer of the photovoltaic apparatus according to Example 3 shown in Fig. 5 respectively;
Fig. 7 is a sectional view showing the structure of a photovoltaic apparatus prepared according to Example 4 of the present invention;
Fig. 8 is a graph showing the intensity levels of X-ray diffraction peaks of an n-type layer, a photoelectric conversion layer and a p-type layer of the photovoltaic apparatus according to Example 4 shown in Fig. 7 respectively;
Fig. 9 is a sectional view showing the structure of a photovoltaic apparatus prepared according to Example 5 of the present invention;
Fig. 10 is a graph showing the intensity levels of X-ray diffraction peaks of an n-type layer, a photoelectric conversion layer and a p-type layer of the photovoltaic apparatus according to Example 5 shown in Fig. 9 respectively;
Fig. 11 is a sectional view showing the structure of a photovoltaic apparatus prepared according to Example 6 of the present invention;
Fig. 12 is a graph showing the intensity levels of X-ray diffraction peaks of an n-type layer, a photoelectric conversion layer and a p-type layer of the photovoltaic apparatus according to Example 6 shown in Fig. 11 respectively;
Fig. 13 is a sectional view showing the structure of a photovoltaic apparatus according to comparative example 1;
Fig. 14 is a graph showing the intensity levels of X-ray diffraction peaks of an n-type layer, a photoelectric conversion layer and a p-type layer of the photovoltaic apparatus according to comparative example 1 shown in Fig. 13 respectively;
Fig. 15 is a sectional view showing the structure of a photovoltaic apparatus according to comparative example 2;
Fig. 16 is a graph showing the intensity levels of X-ray diffraction peaks of an n-type layer, a photoelectric conversion layer and a p-type layer of the photovoltaic apparatus according to comparative example 2 shown in Fig. 15 respectively;
Fig. 17 is a sectional view showing the structure of a photovoltaic apparatus prepared according to Example 7 of the present invention;
Fig. 18 is a graph showing the intensity levels of X-ray diffraction peaks of an n-type layer, a photoelectric conversion layer and a p-type layer of the photovoltaic apparatus according to Example 7 shown in Fig. 17 respectively; and
Fig. 19 is a sectional view showing the structure of a portion around an n-type layer in a photovoltaic apparatus according to a modification of Example 1.

### DESCRIPTION OF THE PREFERRED EMBODIMENTS

Examples of the present invention are now specifically described.

### (Example 1)

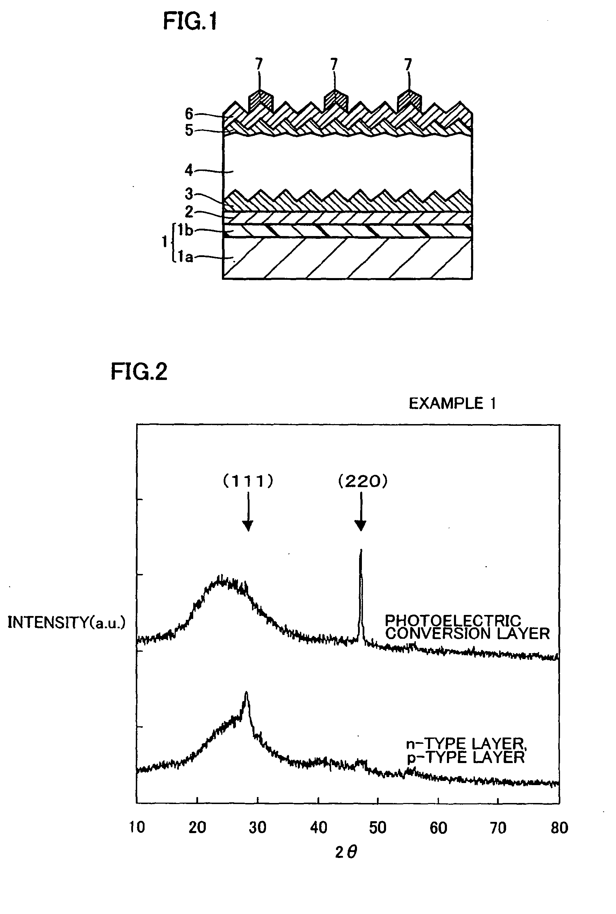

The structure of a photovoltaic apparatus prepared according to Example 1 of the present invention is described with reference to Fig. 1.

In the photovoltaic apparatus according to Example 1, a polyimide resin layer 1b having a thickness of 20 µm is formed on a flat stainless plate 1a of SUS430 having a thickness of 0.15 mm, as shown in Fig. 1. The stainless plate 1a and the polyimide resin layer 1b constitute a substrate 1. A flat back electrode 2 of Ag (silver) having a thickness of 200 nm is formed on the substrate 1 (the polyimide resin layer 1b).

An n-type layer 3 consisting of an n-type microcrystalline silicon layer having a thickness of 50 nm is formed on the back electrode 2. A photoelectric conversion layer 4 consisting of a non-doped microcrystalline silicon layer having a thickness of 2 µm layer is formed on the n-type layer 3. A p-type layer 5 consisting of a p-type microcrystalline silicon layer having a thickness of 20 nm is formed on the photoelectric conversion layer 4. The n-type layer 3, the photoelectric conversion layer 4 and the p-type layer 5 constitute a power generation unit. The n-type layer 3, the photoelectric conversion layer 4 and the p-type layer 5 are examples of the "first non-single-crystalline semiconductor layer", the "second non-single-crystalline semiconductor layer" and the "third non-single-crystalline semiconductor layer" in the present invention respectively.

According to Example 1, the n- and p-type layers 3 and 5 and the photoelectric conversion layer 4 have preferred crystal orientation planes different from each other. More specifically, the n- and p-type layers 3 and 5 have (111)-plane preferred crystal orientation, while the photoelectric conversion layer 4 has (220)-plane preferred crystal orientation. Further, the n- and p-type layers 3 and 5 have pyramidal (square-pyramidal) irregular surfaces, while the photoelectric conversion layer 4 has a loose irregular surface close to a substantially flat surface.

A front transparent electrode 6 of ITO (indium tin oxide) having a thickness of 80 nm is formed on the p-type layer 5. Collectors 7 of Ag having a thickness of 2 µm are formed on prescribed regions of the front transparent electrode 6.

The process of actually preparing the photovoltaic apparatus according to the aforementioned Example 1 is now described.

### [Preparation of Photovoltaic Apparatus]

First, the polyimide resin layer 1b having the thickness of 20 µm was vapor deposition-polymerized onto the flat stainless plate 1a having the thickness of 0.15 mm, thereby preparing the substrate 1 constituted of the stainless plate 1a and the polyimide resin layer 1b as shown in Fig. 1. Thereafter the flat back electrode 2 of Ag having the thickness of 200 nm was formed on the substrate 1 (the polyimide resin layer 1b) by RF magnetron sputtering.

Then, the microcrystalline semiconductor layers constituting the power generation unit were successively formed on the back electrode 2 by plasma CVD method. More specifically, the n-type layer 3 consisting of the n-type microcrystalline silicon layer, the photoelectric conversion layer 4 consisting of the non-doped microcrystalline silicon layer and the p-type layer 5 consisting of the p-type microcrystalline silicon layer were successively formed. The n-type layer 3, the photoelectric conversion layer 4 and the p-type layer 5 were formed to have the thicknesses of 50 nm, 2 µm and 20 nm respectively.

According to Example 1, the photovoltaic apparatus was prepared under the conditions shown in Table 1, so that the n- and p-type layers 3 and 5 have (111)-plane preferred crystal orientation while the photoelectric conversion layer 4 had (220)-plane preferred crystal orientation:

**Table 1**

| | Substrate Temperature (°C) | Reaction Pressure (Pa) | High-Frequency Power (W) | Gas Flow Rate (sccm) |
|---|---|---|---|---|
| n-Type Layer | 160 | 133 | 300 | SiH₄:15 H₂:2000 PH₃:3 |
| Photoelectric Conversion Layer | 200 | 133 | 30 | SiH₄:20 H₂:400 |
| p-Type Layer | 160 | 133 | 240 | SiH₄:10 H₂:2000 B₂H₆:0.2 |

Referring to Table 1, the substrate temperature, the reaction pressure and the high-frequency power were set to 160°C, 133 Pa and 300 W respectively for forming the n-type layer 3 according to Example 1. Further, the flow rates of SiH₄ gas, H₂ gas and PH₃ gas were set to 15 sccm, 2000 sccm and 3 sccm respectively for forming the n-type layer 3.

Further, the substrate temperature, the reaction pressure and the high-frequency power were set to 200°C, 133 Pa and 30 W respectively for forming the photoelectric conversion layer 4. The flow rates of SiH₄ gas and H₂ gas were set to 20 sccm and 400 sccm respectively for forming the photoelectric conversion layer 4.

In addition, the substrate temperature, the reaction pressure and the high-frequency power were set to 160°C, 133 Pa and 240 W respectively for forming the p-type layer 5. The flow rates of SiH₄ gas, H₂ gas and B₂H₆ gas were set to 10 sccm, 2000 sccm and 0.2 sccm respectively for forming the p-type layer 5.

Then, the intensity levels of X-ray diffraction peaks of the n-type layer 3, the photoelectric conversion layer 4 and the p-type layer 5 prepared under the conditions shown in Table 1 were measured respectively.

Referring to Fig. 2, it has been proved that the n-and p-type layers 3 and 5 have substantially similar X-ray diffraction spectra, and the intensity levels of the (111) diffraction peaks of the n- and p-type layers 3 and 5 are higher than those of the (220) diffraction peaks according to Example 1. It has also been proved that the intensity level of the (220) diffraction peak of the photoelectric conversion layer 4 is higher than that of the (111) diffraction peak. In other words, it has been possible to confirm that the n- and p-type layers 3 and 5 have (111)-plane preferred crystal orientation while the photoelectric conversion layer 4 has (220)-plane preferred crystal orientation.

It is known that the surface of a microcrystalline silicon layer formed to have (111)-plane preferred crystal orientation is easily pyramidally irregularized. It is also known that the surface of a microcrystalline silicon layer formed to have (220)-plane preferred crystal orientation is easily flattened.

Thus, it is conceivable that the surfaces of the n-and p-type layers 3 and 5 were pyramidally irregularized while the surface of the photoelectric conversion layer 4 approached a substantially flat shape according to Example 1 due to the aforementioned reason, as shown in Fig. 1.

Then, the front transparent electrode 6 of ITO having the thickness of 80 nm was formed on the p-type layer 5 by RF magnetron sputtering. Thereafter the collectors 7 of Ag having the thickness of 2 µm were formed on the prescribed regions of the front transparent electrode 6 by vacuum evaporation, thereby preparing the photovoltaic apparatus according to Example 1 as shown in Fig. 1.

### (Example 2)

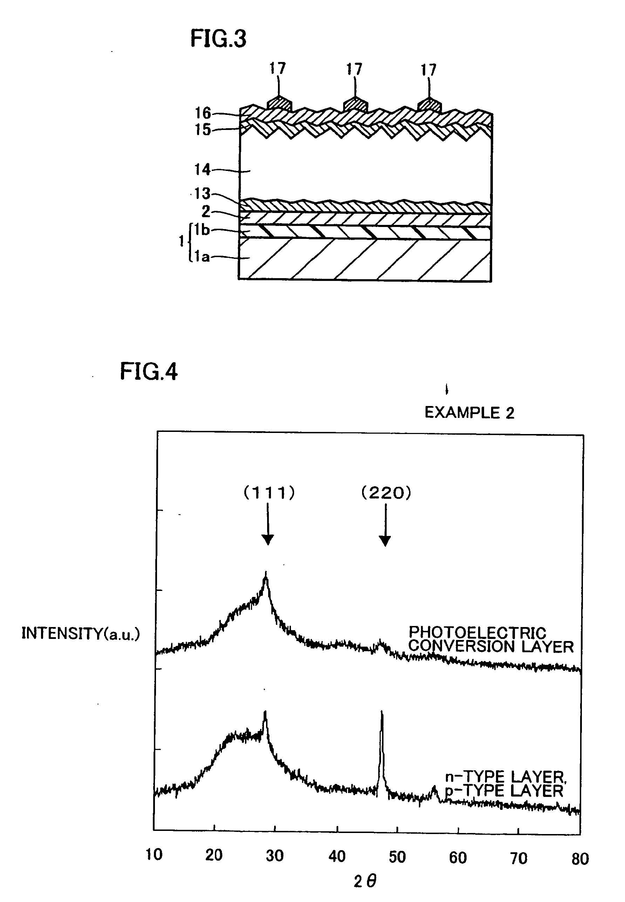

The structure of a photovoltaic apparatus prepared according to Example 2 of the present invention is described with reference to Fig. 3.

In the photovoltaic apparatus according to Example 2, a back electrode 2 is formed on a substrate 1 constituted of a stainless plate 1a and a polyimide resin layer 1b similarly to the aforementioned Example 1, as shown in Fig. 3. An n-type layer 13 consisting of an n-type microcrystalline silicon layer having a thickness of 50 nm is formed on the back electrode 2. A photoelectric conversion layer 14 consisting of a non-doped microcrystalline silicon layer having a thickness of 2 µm is formed on the n-type layer 13. A p-type layer 15 consisting of a p-type microcrystalline silicon layer having a thickness of 20 nm is formed on the photoelectric conversion layer 14. The n-type layer 13, the photoelectric conversion layer 14 and the p-type layer 15 constitute a power generation unit. The n-type layer 13, the photoelectric conversion layer 14 and the p-type layer 15 are examples of the "first non-single-crystalline semiconductor layer", the "second non-single-crystalline semiconductor layer" and the "third non-single-crystalline semiconductor layer" in the present invention respectively.

According to Example 2, the n- and p-type layers 13 and 15 and the photoelectric conversion layer 14 have different preferred crystal orientation planes, similarly to the aforementioned Example 1. According to Example 2, however, the n- and p-type layers 13 and 15 have (220)-plane preferred crystal orientation, while the photoelectric conversion layer 14 has (111)-plane preferred crystal orientation. Further, the n- and p-type layers 13 and 15 have loose irregular surfaces close to substantially flat surfaces, while the photoelectric conversion layer 14 has a pyramidal irregular surface.

A front transparent electrode 16 of ITO having a thickness of 80 nm is formed on the p-type layer 15. Collectors 17 of Ag having a thickness of 2 µm are formed on prescribed regions of the front transparent electrode 16.

A process of actually preparing the photovoltaic apparatus according to the aforementioned Example 2 is now described.

### [Preparation of Photovoltaic Apparatus]

First, the back electrode 2 was formed on the substrate 1 constituted of the stainless plate 1a and the polyimide resin 1b as shown in Fig. 3, similarly to the aforementioned Example 1.

Then, the microcrystalline semiconductor layers constituting the power generation unit were successively formed on the back electrode 2 by CVD, similarly to the aforementioned Example 1. More specifically, the n-type layer consisting of the n-type microcrystalline silicon layer, the photoelectric conversion layer 14 consisting of the non-doped microcrystalline silicon layer and the p-type layer 15 consisting of the p-type microcrystalline silicon layer were successively formed. The n-type layer 13, the photoelectric conversion layer 14 and the p-type layer 15 were formed to have the thicknesses of 50 nm, 2 µm and 20 nm respectively.

According to Example 2, the photovoltaic apparatus was prepared under the conditions shown in Table 2, so that the n- and p-type layers 13 and 15 have (220)-plane preferred crystal orientation and the photoelectric conversion layer 14 has (111)-plane preferred crystal orientation:

**Table 2**

| | Substrate Temperature (°C) | Reaction Pressure (Pa) | High-Frequency Power (W) | Gas Flow Rate (sccm) |
|---|---|---|---|---|
| n-Type Layer | 160 | 133 | 100 | SiH₄:2 H₂:200 PH₃:0.2 |
| Photoelectric Conversion Layer | 200 | 80 | 400 | SiH₄:50 H₂:2000 |
| p-Type Layer | 160 | 133 | 60 | SiH₄:2 H₂:300 B₂H₆:0.2 |

Referring to Table 2, the substrate temperature, the reaction pressure and the high-frequency power were set to 160°C, 133 Pa and 100 W respectively for forming the n-type layer 13 according to Example 2. Further, the flow rates of SiH₄ gas, H₂ gas and PH₃ gas were set to 2 sccm, 200 sccm and 0.2 sccm respectively for forming the n-type layer 13.

Further, the substrate temperature, the reaction pressure and the high-frequency power were set to 200°C, 80 Pa and 400 W respectively for forming the photoelectric conversion layer 14. The flow rates of SiH₄ gas and H₂ gas were set to 50 sccm and 2000 sccm respectively for forming the photoelectric conversion layer 14.

In addition, the substrate temperature, the reaction pressure and the high-frequency power were set to 160°C, 133 Pa and 60 W respectively for forming the p-type layer 15. The flow rates of SiH₄ gas, H₂ gas and B₂H₆ gas were set to 2 sccm, 300 sccm and 0.2 sccm respectively for forming the p-type layer 15.

Then, the intensity levels of X-ray diffraction peaks of the n-type layer 13, the photoelectric conversion layer 14 and the p-type layer 15 prepared under the conditions shown in Table 2 were measured respectively.

Referring to Fig. 4, it has been proved that the n-and p-type layers 13 and 15 have substantially similar X-ray diffraction spectra, and that the intensity levels of the (220) diffraction peaks of the n- and p-type layers 13 and 15 are higher than those of the (111) diffraction peaks according to Example 2. It has also been proved that the intensity level of the (111) diffraction peak of the photoelectric conversion layer 14 is higher than that of the (220) diffraction peak. In other words, it has been possible to confirm that the n- and p-type layers 13 and 15 have (220)-plane preferred crystal orientation, while the photoelectric conversion layer 14 has (111)-plane preferred crystal orientation. Thus, it is conceivable that the surfaces of the n- and p-type layers 13 and 15 were loosely irregularized to approach substantially flat surfaces while the surface of the photoelectric conversion layer 14 was pyramidally irregularized according to Example 2 due to the aforementioned reason, as shown in Fig. 3.

Then, the front transparent electrode 16 of ITO having the thickness of 80 nm was formed on the p-type layer 15 by RF magnetron sputtering, similarly to the aforementioned Example 1. Further, the collectors 17 of Ag having the thickness of 2 µm were formed on the prescribed regions of the front transparent electrode 16 by vacuum evaporation. Thus, the photovoltaic apparatus according to Example 2 was prepared as shown in Fig. 3.

### (Example 3)

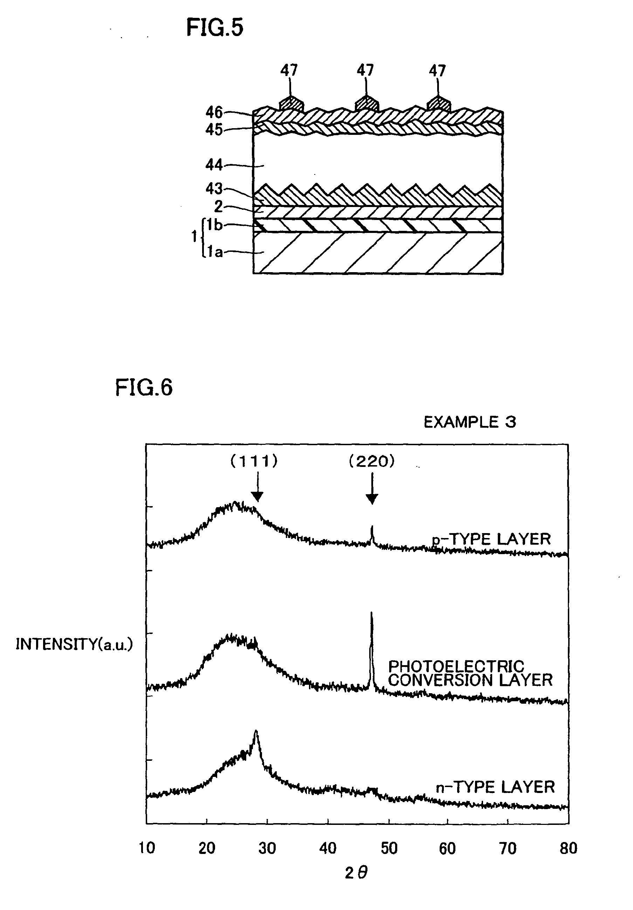

Referring to Fig. 5, a photovoltaic apparatus according to Example 3 of the present invention is so formed that an n-type layer 43 has (111)-plane preferred crystal orientation while a photoelectric conversion layer 44 and a p-type layer 45 have (220)-plane preferred crystal orientation, dissimilarly to the aforementioned Examples 1 and 2.

In the photovoltaic apparatus according to Example 3, a back electrode 2 is formed on a substrate 1 constituted of a stainless plate 1a and a polyimide resin layer 1b as shown in Fig. 5, similarly to the aforementioned Example 1. The n-type layer 43 consisting of an n-type microcrystalline silicon layer having a thickness of 50 nm is formed on the back electrode 2. The photoelectric conversion layer 44 consisting of a non-doped microcrystalline silicon layer having a thickness of 2 µm is formed on the n-type layer 43. The p-type layer 45 consisting of a p-type microcrystalline silicon layer having a thickness of 20 nm is formed on the photoelectric conversion layer 44. The n-type layer 43, the photoelectric conversion layer 44 and the p-type layer 45 constitute a power generation unit. The n-type layer 43, the photoelectric conversion layer 44 and the p-type layer 45 are examples of the "first non-single-crystalline semiconductor layer", the "second non-single-crystalline semiconductor layer" and the "third non-single-crystalline semiconductor layer" in the present invention respectively.

According to Example 3, the n-type layer 43 has a preferred crystal orientation plane different from that of the photoelectric conversion layer 44, while the p-type layer 45 has the same preferred crystal orientation plane as the photoelectric conversion layer 44. More specifically, the n-type layer 43 has (111)-plane preferred crystal orientation, while the photoelectric conversion layer 44 and the p-type layer 45 have (220) preferred crystal orientation. Further, the n-type layer 43 has a pyramidal irregular surface, while the photoelectric conversion layer 44 and the p-type layer 45 have loose irregular surfaces close to substantially flat surfaces.

A front transparent electrode 46 of ITO having a thickness of 80 nm is formed on the p-type layer 45. Collectors 47 of Ag having a thickness of 2 µm are formed on prescribed regions of the front transparent electrode 46.

A process of actually preparing the photovoltaic apparatus according to the aforementioned Example 3 is now described.

### [Preparation of Photovoltaic Apparatus]

First, the back electrode 2 was formed on the substrate 1 constituted of the stainless plate 1a and the polyimide resin layer 1b as shown in Fig. 5, similarly to the aforementioned Example 1.

Then, the microcrystalline semiconductor layers constituting the power generation unit were successively formed on the back electrode 2 by CVD, similarly to the aforementioned Example 1. More specifically, the n-type layer 43 consisting of the n-type microcrystalline silicon layer, the photoelectric conversion layer 44 consisting of the non-doped microcrystalline silicon layer and the p-type layer 45 consisting of the p-type microcrystalline silicon layer were successively formed. The n-type layer 43, the photoelectric conversion layer 44 and the p-type layer 45 were formed to have the thicknesses of 50 nm, 2 µm and 20 nm respectively.

According to Example 3, the photovoltaic apparatus was prepared under the conditions shown in Table 3, so that the n-type layer 43 has (111)-plane preferred crystal orientation while the photoelectric conversion layer 44 and the p-type layer 45 have (220)-plane preferred crystal orientation:

**Table 3**

| | Substrate Temperature (°C) | Reaction Pressure (Pa) | High-Frequency Power (W) | Gas Flow Rate (sccm) |
|---|---|---|---|---|
| n-Type Layer | 160 | 133 | 100 | SiH₄:3 H₂:200 PH₃:0.6 |
| Photoelectric Conversion Layer | 200 | 133 | 30 | SiH₄:20 H₂:400 |
| p-Type Layer | 160 | 133 | 60 | SiH₄:2 H₂:150 B₂H₆:0.2 |

Referring to Table 3, the substrate temperature, the reaction pressure and the high-frequency power were set to 160°C, 133 Pa and 100 W respectively for forming the n-type layer 43 according to Example 3. Further, the flow rates of SiH₄ gas, H₂ gas and PH₃ gas were set to 3 sccm, 200 sccm and 0.6 sccm respectively for forming the n-type layer 43.

Further, the substrate temperature, the reaction pressure and the high-frequency power were set to 200°C, 133 Pa and 30 W respectively for forming the photoelectric conversion layer 44. The flow rates of SiH₄ gas and H₂ gas were set to 20 sccm and 400 sccm respectively for forming the photoelectric conversion layer 44.

In addition, the substrate temperature, the reaction pressure and the high-frequency power were set to 160°C, 133 Pa and 60 W respectively for forming the p-type layer 45. The flow rates of SiH₄ gas, H₂ gas and B₂H₆ gas were set to 2 sccm, 150 sccm and 0.2 sccm respectively for forming the p-type layer 45.

Then, the intensity levels of X-ray diffraction peaks of the n-type layer 43, the photoelectric conversion layer 44 and the p-type layer 45 prepared under the conditions shown in Table 3 were measured respectively.

Referring to Fig. 6, it has been proved that the intensity level of the (111) diffraction peak of the n-type layer 43 is higher than that of the (220) diffraction peak according to Example 3. It has also been proved that the intensity levels of the (220) diffraction peaks of the photoelectric conversion layer 44 and the p-type layer 45 are higher than those of the (111) diffraction peaks. In other words, it has been possible to confirm that the n-type layer 43 has (111)-plane preferred crystal orientation while the photoelectric conversion layer 44 and the p-type layer 45 have (220)-plane preferred crystal orientation according to Example 3. Thus, it is conceivable that the surface of the n-type layers 43 was pyramidally irregularized while the surfaces of the photoelectric conversion layer 44 and the p-type layer 45 were loosely irregularized to reach substantially flat surfaces according to Example 3 due to the aforementioned reason, as shown in Fig. 5.

Then, the front transparent electrode 46 of ITO having the thickness of 80 nm was formed on the p-type layer 45 by RF magnetron sputtering, similarly to the aforementioned Example 1. Further, the collectors 47 of Ag having the thickness of 2 µm were formed on the prescribed regions of the front transparent electrode 46 by vacuum evaporation. Thus, the photovoltaic apparatus according to Example 3 was prepared as shown in Fig. 5.

### (Example 4)

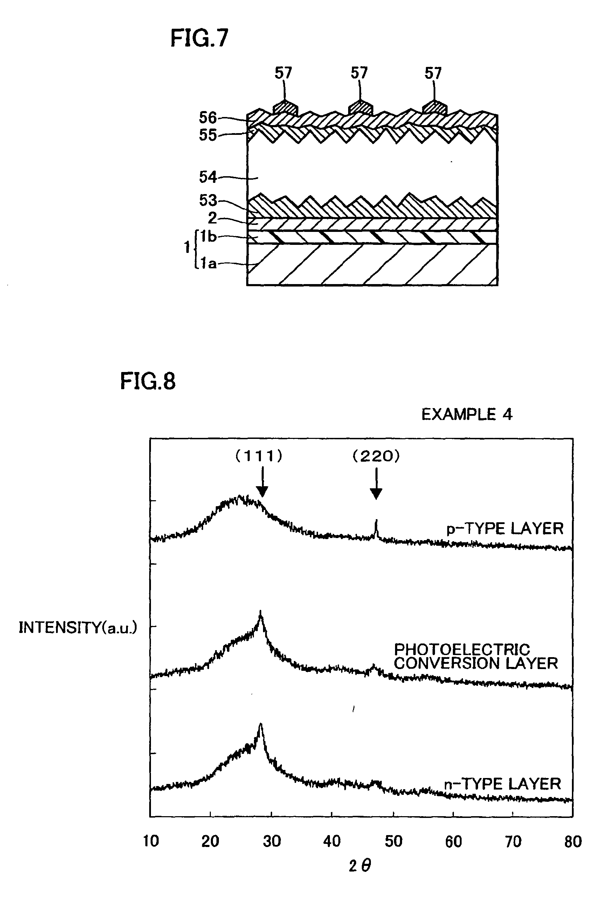

Referring to Fig. 7, a photovoltaic apparatus according to Example 4 of the present invention is so formed that an n-type layer 53 and a photoelectric conversion layer 54 have (111)-plane preferred crystal orientation while a p-type layer 55 has (220)-plane preferred crystal orientation, dissimilarly to the aforementioned Example 3.

In the photovoltaic apparatus according to Example 4, a back electrode 2 is formed on a substrate 1 constituted of a stainless plate 1a and a polyimide resin layer 1b as shown in Fig. 7, similarly to the aforementioned Example 1. The n-type layer 53 consisting of an n-type microcrystalline silicon layer having a thickness of 50 nm is formed on the back electrode 2. The photoelectric conversion layer 54 consisting of a non-doped microcrystalline silicon layer having a thickness of 2 µm is formed on the n-type layer 53. The p-type layer 55 consisting of a p-type microcrystalline silicon layer having a thickness of 20 nm is formed on the photoelectric conversion layer 54. The n-type layer 53, the photoelectric conversion layer 54 and the p-type layer 55 constitute a power generation unit. The n-type layer 53, the photoelectric conversion layer 54 and the p-type layer 55 are examples of the "first non-single-crystalline semiconductor layer", the "second non-single-crystalline semiconductor layer" and the "third non-single-crystalline semiconductor layer" in the present invention respectively.

According to Example 4, the n-type layer 53 has the same preferred crystal orientation plane as the photoelectric conversion layer 54, while the p-type layer 55 has a preferred crystal orientation plane different from that of the photoelectric conversion layer 54. More specifically, the n-type layer 53 and the photoelectric conversion layer 54 have (111)-plane preferred crystal orientation, while the p-type layer 55 has (220) preferred crystal orientation. Further, the n-type layer 53 and the photoelectric conversion layer 54 have pyramidal irregular surfaces, while the p-type layer 55 has a loose irregular surface close to a substantially flat surface.

A front transparent electrode 56 of ITO having a thickness of 80 nm is formed on the p-type layer 55. Collectors 57 of Ag having a thickness of 2 µm are formed on prescribed regions of the front transparent electrode 56.

A process of actually preparing the photovoltaic apparatus according to the aforementioned Example 4 is now described.

### [Preparation of Photovoltaic Apparatus]

First, the back electrode 2 was formed on the substrate 1 constituted of the stainless plate 1a and the polyimide resin layer 1b as shown in Fig. 7, similarly to the aforementioned Example 1.

Then, the microcrystalline semiconductor layers constituting the power generation unit were successively formed on the back electrode 2 by CVD, similarly to the aforementioned Example 1. More specifically, the n-type layer 53 consisting of the n-type microcrystalline silicon layer, the photoelectric conversion layer 54 consisting of the non-doped microcrystalline silicon layer and the p-type layer 55 consisting of the p-type microcrystalline silicon layer were successively formed. The n-type layer 53, the photoelectric conversion layer 54 and the p-type layer 55 were formed to have the thicknesses of 50 nm, 2 µm and 20 nm respectively.

According to Example 4, the photovoltaic apparatus was prepared under the conditions shown in Table 4, so that the n-type layer 53 and the photoelectric conversion layer 54 have (111)-plane preferred crystal orientation while the p-type layer 55 has (220)-plane preferred crystal orientation:

**Table 4**

| | Substrate Temperature (°C) | Reaction Pressure (Pa) | High-Frequency Power (W) | Gas Flow Rate (sccm) |
|---|---|---|---|---|
| n-Type Layer | 160 | 133 | 100 | SiH₄:3 H₂:200 PH₃:0.6 |
| Photoelectric Conversion Layer | 200 | 80 | 400 | SiH₄:50 H₂:2000 |
| p-Type Layer | 160 | 133 | 60 | SiH₄:2 H₂:150 B₂H₆:0.2 |

Referring to Table 4, the substrate temperature, the reaction pressure and the high-frequency power were set to 160°C, 133 Pa and 100 W respectively for forming the n-type layer 53 according to Example 4. Further, the flow rates of SiH₄ gas, H₂ gas and PH₃ gas were set to 3 sccm, 200 sccm and 0.6 sccm respectively for forming the n-type layer 53.

Further, the substrate temperature, the reaction pressure and the high-frequency power were set to 200°C, 80 Pa and 400 W respectively for forming the photoelectric conversion layer 54. The flow rates of SiH₄ gas and H₂ gas were set to 50 sccm and 2000 sccm respectively for forming the photoelectric conversion layer 54.

In addition, the substrate temperature, the reaction pressure and the high-frequency power were set to 160°C, 133 Pa and 60 W respectively for forming the p-type layer 55. The flow rates of SiH₄ gas, H₂ gas and B₂H₆ gas were set to 2 sccm, 150 sccm and 0.2 sccm respectively for forming the p-type layer 55.

Then, the intensity levels of X-ray diffraction peaks of the n-type layer 53, the photoelectric conversion layer 54 and the p-type layer 55 prepared under the conditions shown in Table 4 were measured respectively.

Referring to Fig. 8, it has been proved that the intensity levels of the (111) diffraction peaks of the n-type layer 53 and the photoelectric conversion layer 54 are higher than those of the (220) diffraction peaks according to Example 4. It has also been proved that the intensity level of the (220) diffraction peak of the p-type layer 55 is higher than that of the (111) diffraction peak. In other words, it has been possible to confirm that the n-type layer 53 and the photoelectric conversion layer 54 have (111)-plane preferred crystal orientation while the p-type layer 55 has (220)-plane preferred crystal orientation according to Example 4. Thus, it is conceivable that the surfaces of the n-type layer 53 and the photoelectric conversion layer 54 were pyramidally irregularized while the surface of the p-type layer 55 was loosely irregularized to be approach a substantially flat shape according to Example 4 due to the aforementioned reason, as shown in Fig. 7.

Then, the front transparent electrode 56 of ITO having the thickness of 80 nm was formed on the p-type layer 55 by RF magnetron sputtering, similarly to the aforementioned Example 1. Further, the collectors 57 of Ag having the thickness of 2 µm were formed on the prescribed regions of the front transparent electrode 56 by vacuum evaporation. Thus, the photovoltaic apparatus according to Example 4 was prepared as shown in Fig. 7.

### (Example 5)

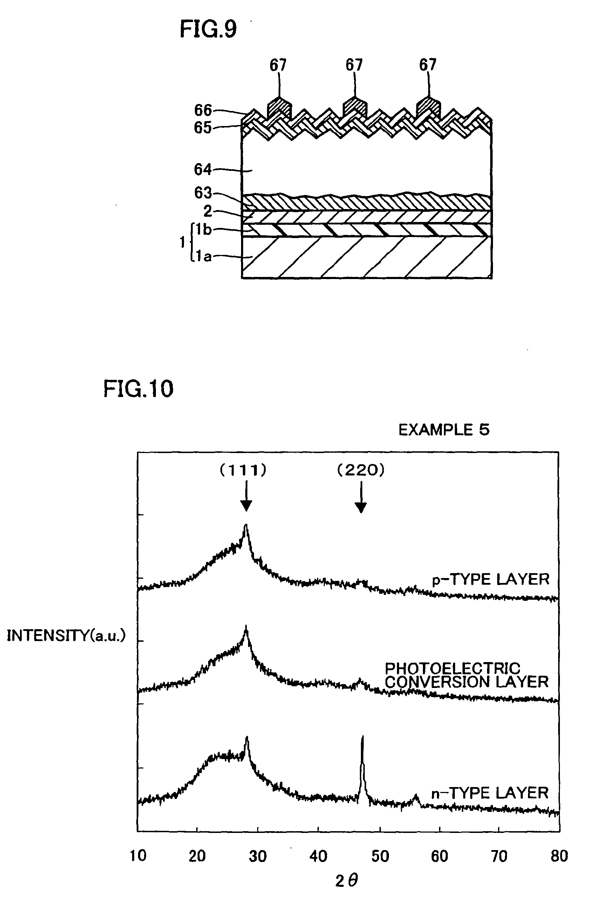

Referring to Fig. 9, a photovoltaic apparatus according to Example 5 of the present invention is so formed that an n-type layer 63 has (220)-plane preferred crystal orientation while a photoelectric conversion layer 64 and a p-type layer 65 have (111)-plane preferred crystal orientation, dissimilarly to the aforementioned Examples 3 and 4.

In the photovoltaic apparatus according to Example 5, a back electrode 2 is formed on a substrate 1 constituted of a stainless plate 1a and a polyimide resin layer 1b as shown in Fig. 9, similarly to the aforementioned Example 1. The n-type layer 63 consisting of an n-type microcrystalline silicon layer having a thickness of 50 nm is formed on the back electrode 2. The photoelectric conversion layer 64 consisting of a non-doped microcrystalline silicon layer having a thickness of 2 µm is formed on the n-type layer 63. The p-type layer 65 consisting of a p-type microcrystalline silicon layer having a thickness of 20 nm is formed on the photoelectric conversion layer 64. The n-type layer 63, the photoelectric conversion layer 64 and the p-type layer 65 constitute a power generation unit. The n-type layer 63, the photoelectric conversion layer 64 and the p-type layer 65 are examples of the "first non-single-crystalline semiconductor layer", the "second non-single-crystalline semiconductor layer" and the "third non-single-crystalline semiconductor layer" in the present invention respectively.

According to Example 5, the n-type layer 63 has a preferred crystal orientation plane different from that of the photoelectric conversion layer 64, while the p-type layer 65 has the same preferred crystal orientation plane as the photoelectric conversion layer 64. More specifically, the n-type layer 63 has (220)-plane preferred crystal orientation, while the photoelectric conversion layer 64 and the p-type layer 65 have (111)-plane preferred crystal orientation. Further, the n-type layer 63 has a loose irregular surface close to a substantially flat surface, while the photoelectric conversion layer 64 and the p-type layer 65 have pyramidal irregular surfaces.

A front transparent electrode 66 of ITO having a thickness of 80 nm is formed on the p-type layer 65. Collectors 67 of Ag having a thickness of 2 µm are formed on prescribed regions of the front transparent electrode 66.

A process of actually preparing the photovoltaic apparatus according to the aforementioned Example 5 is now described.

### [Preparation of Photovoltaic Apparatus]

First, the back electrode 2 was formed on the substrate 1 constituted of the stainless plate 1a and the polyimide resin layer 1b as shown in Fig. 9, similarly to the aforementioned Example 1.

Then, the microcrystalline semiconductor layers constituting the power generation unit were successively formed on the back electrode 2 by CVD, similarly to the aforementioned Example 1. More specifically, the n-type layer 63 consisting of the n-type microcrystalline silicon layer, the photoelectric conversion layer 64 consisting of the non-doped microcrystalline silicon layer and the p-type layer 65 consisting of the p-type microcrystalline silicon layer were successively formed. The n-type layer 63, the photoelectric conversion layer 64 and the p-type layer 65 were formed to have the thicknesses of 50 nm, 2 µm and 20 nm respectively.

According to Example 5, the photovoltaic apparatus was prepared under the conditions shown in Table 5, so that the n-type layer 63 has (220)-plane preferred crystal orientation while the photoelectric conversion layer 64 and the p-type layer 65 have (111)-plane preferred crystal orientation:

**Table 5**

| | Substrate Temperature (°C) | Reaction Pressure (Pa) | High-Frequency Power (W) | Gas Flow Rate (sccm) |
|---|---|---|---|---|
| n-Type Layer | 160 | 133 | 100 | SiH₄:2 H₂:200 PH₃:0.2 |
| Photoelectric Conversion Layer | 200 | 80 | 400 | SiH₄:50 H₂:2000 |
| p-Type Layer | 160 | 133 | 240 | SiH₄:10 H₂:2000 B₂H₆:0.2 |

Referring to Table 5, the substrate temperature, the reaction pressure and the high-frequency power were set to 160°C, 133 Pa and 100 W respectively for forming the n-type layer 63 according to Example 5. Further, the flow rates of SiH₄ gas, H₂ gas and PH₃ gas were set to 2 sccm, 200 sccm and 0.2 sccm respectively for forming the n-type layer 63.

Further, the substrate temperature, the reaction pressure and the high-frequency power were set to 200°C, 80 Pa and 400 W respectively for forming the photoelectric conversion layer 64. The flow rates of SiH₄ gas and H₂ gas were set to 50 sccm and 2000 sccm respectively for forming the photoelectric conversion layer 64.

In addition, the substrate temperature, the reaction pressure and the high-frequency power were set to 160°C, 133 Pa and 240 W respectively for forming the p-type layer 65. The flow rates of SiH₄ gas, H₂ gas and B₂H₆ gas were set to 10 sccm, 2000 sccm and 0.2 sccm respectively for forming the p-type layer 65.

Then, the intensity levels of X-ray diffraction peaks of the n-type layer 63, the photoelectric conversion layer 64 and the p-type layer 65 prepared under the conditions shown in Table 5 were measured respectively.

Referring to Fig. 10, it has been proved that the intensity level of the (220) diffraction peak of the n-type layer 63 is higher than that of the (111) diffraction peak according to Example 5. It has also been proved that the intensity levels of the (111) diffraction peaks of the photoelectric conversion layer 64 and the p-type layer 65 are higher than those of the (220) diffraction peaks. In other words, it has been possible to confirm that the n-type layer 63 has (220)-plane preferred crystal orientation while the photoelectric conversion layer 64 and the p-type layer 65 have (111)-plane preferred crystal orientation according to Example 5. Thus, it is conceivable that the surface of the n-type layers 63 was loosely irregularized to approach a substantially flat surface while the surfaces of the photoelectric conversion layer 64 and the p-type layer 65 were pyramidally irregularized according to Example 5 due to the aforementioned reason, as shown in Fig. 9.

Then, the front transparent electrode 66 of ITO having the thickness of 80 nm was formed on the p-type layer 65 by RF magnetron sputtering, similarly to the aforementioned Example 1. Further, the collectors 67 of Ag having the thickness of 2 µm were formed on the prescribed regions of the front transparent electrode 66 by vacuum evaporation. Thus, the photovoltaic apparatus according to Example 5 was prepared as shown in Fig. 9.

### (Example 6)

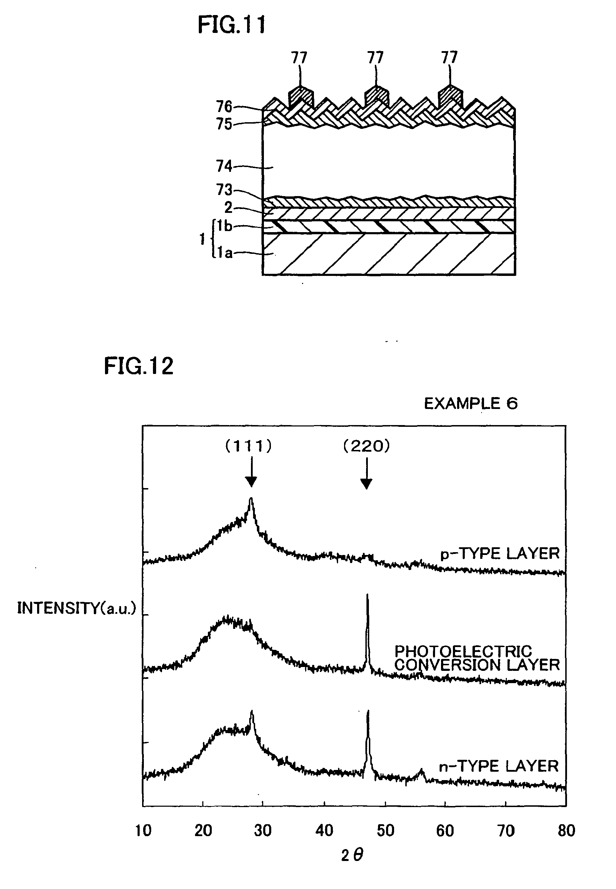

Referring to Fig. 11, a photovoltaic apparatus according to Example 6 of the present invention is so formed that an n-type layer 73 and a photoelectric conversion layer 74 have (220)-plane preferred crystal orientation while a p-type layer 75 has (111)-plane preferred crystal orientation, dissimilarly to the aforementioned Examples 3 to 5.

In the photovoltaic apparatus according to Example 6, a back electrode 2 is formed on a substrate 1 constituted of a stainless plate 1a and a polyimide resin layer 1b as shown in Fig. 11, similarly to the aforementioned Example 1. The n-type layer 73 consisting of an n-type microcrystalline silicon layer having a thickness of 50 nm is formed on the back electrode 2. The photoelectric conversion layer 74 consisting of a non-doped microcrystalline silicon layer having a thickness of 2 µm is formed on the n-type layer 73. The p-type layer 75 consisting of a p-type microcrystalline silicon layer having a thickness of 20 nm is formed on the photoelectric conversion layer 74. The n-type layer 73, the photoelectric conversion layer 74 and the p-type layer 75 constitute a power generation unit. The n-type layer 73, the photoelectric conversion layer 74 and the p-type layer 75 are examples of the "first non-single-crystalline semiconductor layer", the "second non-single-crystalline semiconductor layer" and the "third non-single-crystalline semiconductor layer" in the present invention respectively.

According to Example 6, the n-type layer 73 has the same preferred crystal orientation plane as the photoelectric conversion layer 74, while the p-type layer 75 has a preferred crystal orientation plane different from that of the photoelectric conversion layer 74. More specifically, the n-type layer 73 and the photoelectric conversion layer 74 have (220)-plane preferred crystal orientation, while the p-type layer 75 has (111)-plane preferred crystal orientation. Further, the n-type layer 73 and the photoelectric conversion layer 74 have loose irregular surfaces close to substantially flat surfaces, while the p-type layer 75 has a pyramidal irregular surface.

A front transparent electrode 76 of ITO having a thickness of 80 nm is formed on the p-type layer 75. Collectors 77 of Ag having a thickness of 2 µm are formed on prescribed regions of the front transparent electrode 76.

A process of actually preparing the photovoltaic apparatus according to the aforementioned Example 6 is now described.

### [Preparation of Photovoltaic Apparatus]

First, the back electrode 2 was formed on the substrate 1 constituted of the stainless plate 1a and the polyimide resin layer 1b as shown in Fig. 11, similarly to the aforementioned Example 1.

Then, the microcrystalline semiconductor layers constituting the power generation unit were successively formed on the back electrode 2 by CVD, similarly to the aforementioned Example 1. More specifically, the n-type layer 73 consisting of the n-type microcrystalline silicon layer, the photoelectric conversion layer 74 consisting of the non-doped microcrystalline silicon layer and the p-type layer 75 consisting of the p-type microcrystalline silicon layer were successively formed. The n-type layer 73, the photoelectric conversion layer 74 and the p-type layer 75 were formed to have the thicknesses of 50 nm, 2 µm and 20 nm respectively.

According to Example 6, the photovoltaic apparatus was prepared under the conditions shown in Table 6, so that the n-type layer 73 and the photoelectric conversion layer 74 have (220)-plane preferred crystal orientation while the p-type layer 75 has (111)-plane preferred crystal orientation:

**Table 6**

| | Substrate Temperature (°C) | Reaction Pressure (Pa) | High-Frequency Power (W) | Gas Flow Rate (sccm) |
|---|---|---|---|---|
| n-Type Layer | 160 | 133 | 100 | SiH₄:2 H₂:200 PH₃:0.2 |
| Photoelectric Conversion Layer | 200 | 133 | 30 | SiH₄:20 H₂:400 |
| p-Type Layer | 160 | 133 | 240 | SiH₄:10 H₂:2000 B₂H₆:0.2 |

Referring to Table 6, the substrate temperature, the reaction pressure and the high-frequency power were set to 160°C, 133 Pa and 100 W respectively for forming the n-type layer 73 according to Example 6. Further, the flow rates of SiH₄ gas, H₂ gas and PH₃ gas were set to 2 sccm, 200 sccm and 0.2 sccm respectively for forming the n-type layer 73.

Further, the substrate temperature, the reaction pressure and the high-frequency power were set to 200°C, 133 Pa and 30 W respectively for forming the photoelectric conversion layer 74. The flow rates of SiH₄ gas and H₂ gas were set to 20 sccm and 400 sccm respectively for forming the photoelectric conversion layer 74.

In addition, the substrate temperature, the reaction pressure and the high-frequency power were set to 160°C, 133 Pa and 240 W respectively for forming the p-type layer 75. The flow rates of SiH₄ gas, H₂ gas and B₂H₆ gas were set to 10 sccm, 2000 sccm and 0.2 sccm respectively for forming the p-type layer 75.

Then, the intensity levels of X-ray diffraction peaks of the n-type layer 73, the photoelectric conversion layer 74 and the p-type layer 75 prepared under the conditions shown in Table 6 were measured respectively.

Referring to Fig. 12, it has been proved that the intensity levels of the (220) diffraction peaks of the n-type layer 73 and the photoelectric conversion layer 74 are higher than those of the (111) diffraction peaks according to Example 6. It has also been proved that the intensity level of the (111) diffraction peak of the p-type layer 75 is higher than that of the (220) diffraction peak. In other words, it has been possible to confirm that the n-type layer 73 and the photoelectric conversion layer 74 have (220)-plane preferred crystal orientation while the p-type layer 75 has (111)-plane preferred crystal orientation according to Example 6. Thus, it is conceivable that the surfaces of the n-type layer 73 and the photoelectric conversion layer 74 were loosely irregularized to approach substantially flat surfaces while the surface of the p-type layer 75 was pyramidally irregularized according to Example 6 due to the aforementioned reason, as shown in Fig. 11.

Then, the front transparent electrode 76 of ITO having the thickness of 80 nm was formed on the p-type layer 75 by RF magnetron sputtering, similarly to the aforementioned Example 1. Further, the collectors 77 of Ag having the thickness of 2 µm were formed on the prescribed regions of the front transparent electrode 76 by vacuum evaporation. Thus, the photovoltaic apparatus according to Example 6 was prepared as shown in Fig. 11.

Then, photovoltaic apparatuses according to comparative examples 1 and 2 for the aforementioned Examples 1 to 6 were prepared as follows:

### (Comparative Example 1)

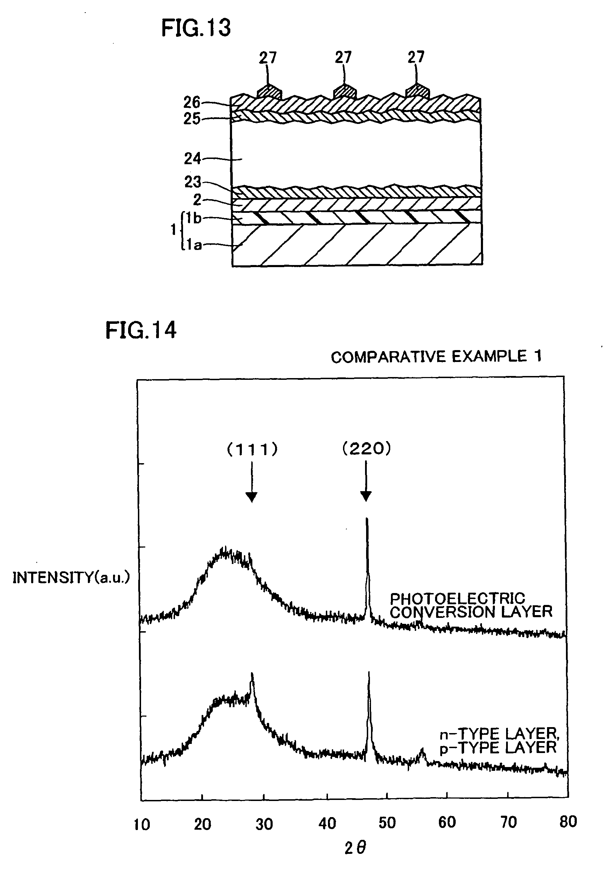

A process of preparing the photovoltaic apparatus according to comparative example 1 is described with reference to Figs. 13 and 14.

### [Preparation of Photovoltaic Apparatus]

First, a back electrode 2 was formed on a substrate 1 constituted of a stainless plate 1a and a polyimide resin layer 1b as shown in Fig. 13, similarly to the aforementioned Example 1.

Then, microcrystalline semiconductor layers constituting a power generation unit were successively formed on the back electrode 2 by CVD, similarly to the aforementioned Example 1. More specifically, an n-type layer 23 consisting of an n-type microcrystalline silicon layer, a photoelectric conversion layer 24 consisting of a non-doped microcrystalline silicon layer and a p-type layer 25 consisting of a p-type microcrystalline silicon layer were successively formed. The n-type layer 23, the photoelectric conversion layer 24 and the p-type layer 25 were formed to have thicknesses of 50 nm, 2 µm and 20 nm respectively.

According to comparative example 1, the photovoltaic apparatus was prepared under the following conditions, so that all of the n-type layer 23, the photoelectric conversion layer 24 and the p-type layer 25 have (220)-plane preferred crystal orientation:

**Table 7**

| | Substrate Temperature (°C) | Reaction Pressure (Pa) | High-Frequency Power (W) | Gas Flow Rate (sccm) |
|---|---|---|---|---|
| n-Type Layer | 160 | 133 | 100 | SiH₄:2 H₂:200 PH₃:0.2 |
| Photoelectric Conversion Layer | 200 | 133 | 30 | SiH₄:20 H₂:400 |
| p-Type Layer | 160 | 133 | 60 | SiH₄:2 H₂:300 B₂H₆:0.2 |

Referring to Table 7, the substrate temperature, the reaction pressure and the high-frequency power were set to 160°C, 133 Pa and 100 W respectively for forming the n-type layer 23 according to comparative example 1. Further, the flow rates of SiH₄ gas, H₂ gas and PH₃ gas were set to 2 sccm, 200 sccm and 0.2 sccm respectively for forming the n-type layer 23.

Further, the substrate temperature, the reaction pressure and the high-frequency power were set to 200°C, 133 Pa and 30 W respectively for forming the photoelectric conversion layer 24. The flow rates of SiH₄ gas and H₂ gas were set to 20 sccm and 400 sccm respectively for forming the photoelectric conversion layer 24.

In addition, the substrate temperature, the reaction pressure and the high-frequency power were set to 160°C, 133 Pa and 60 W respectively for forming the p-type layer 25. The flow rates of SiH₄ gas, H₂ gas and B₂H₆ gas were set to 2 sccm, 300 sccm and 0.2 sccm respectively for forming the p-type layer 25.

Then, the intensity levels of X-ray diffraction peaks of the n-type layer 23, the photoelectric conversion layer 24 and the p-type layer 25 prepared under the conditions shown in Table 7 were measured respectively.

It has been proved that the n- and p-type layers 23 and 25 have substantially similar X-ray diffraction spectra, and the intensity levels of the (220) diffraction peaks of the n- and p-type layers 23 and 25 are higher than those of the (111) diffraction peaks in comparative example 1, as shown in Fig. 14. It has also been proved that the intensity level of the (220) diffraction peak of the photoelectric conversion layer 24 is also higher than that of the (111) diffraction peak. In other words, it has been possible to confirm that all of the n-type layer 23, the photoelectric conversion layer 24 and the p-type layer 25 have (220)-plane preferred crystal orientation according to comparative example 1. Thus, it is conceivable that all of the surfaces of the n-type layer 23, the photoelectric conversion layer 24 and the p-type layer 25 were loosely irregularized to approach substantially flat surfaces according to comparative example 1 due to the aforementioned reason, as shown in Fig. 13.

Then, a front transparent electrode 26 of ITO having a thickness of 80 nm was formed on the p-type layer 25 by RF magnetron sputtering, similarly to the aforementioned Example 1. Further, collectors 27 of Ag having a thickness of 2 µm were formed on prescribed regions of the front transparent electrode 26 by vacuum evaporation. Thus, the photovoltaic apparatus according to comparative example 1 was prepared as shown in Fig. 13.

### (Comparative Example 2)

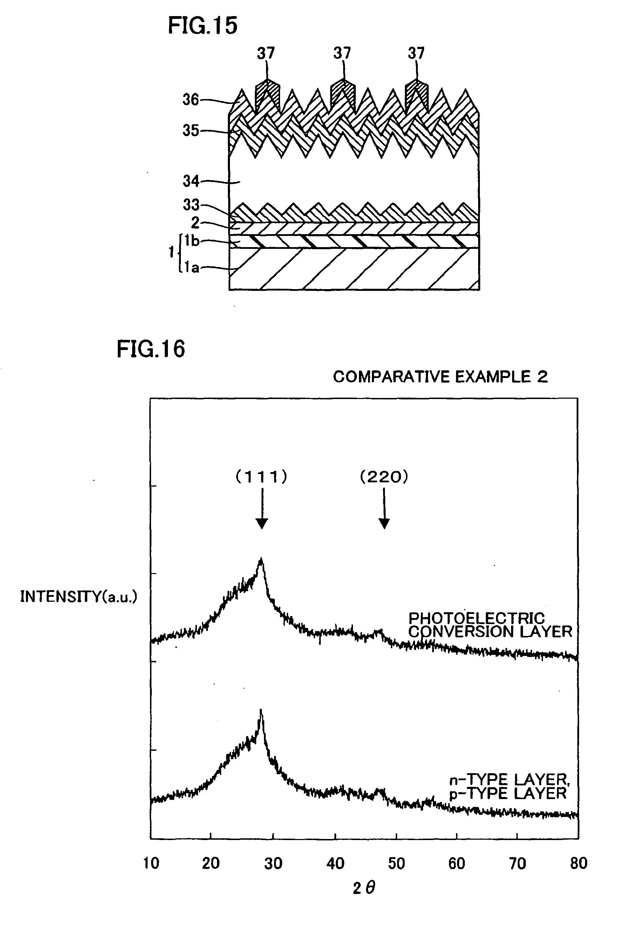

A process of preparing the photovoltaic apparatus according to comparative example 2 is described with reference to Figs. 15 and 16.

### [Preparation of Photovoltaic Apparatus]

First, a back electrode 2 was formed on a substrate 1 constituted of a stainless plate 1a and a polyimide resin layer 1b as shown in Fig. 15, similarly to the aforementioned Example 1.

Then, microcrystalline semiconductor layers constituting a power generation unit were successively formed on the back electrode 2 by CVD, similarly to the aforementioned Example 1. More specifically, an n-type layer 33 consisting of an n-type microcrystalline silicon layer, a photoelectric conversion layer 34 consisting of a non-doped microcrystalline silicon layer and a p-type layer 35 consisting of a p-type microcrystalline silicon layer were successively formed. The n-type layer 33, the photoelectric conversion layer 34 and the p-type layer 35 were formed to have thicknesses of 50 nm, 2 µm and 20 nm respectively.

According to comparative example 2, the photovoltaic apparatus was prepared under the following conditions, so that all of the n-type layer 33, the photoelectric conversion layer 34 and the p-type layer 35 have (111)-plane preferred crystal orientation:

**Table 8**

| | Substrate Temperature (°C) | Reaction Pressure (Pa) | High-Frequency Power (W) | Gas Flow Rate (sccm) |
|---|---|---|---|---|
| n-Type Layer | 160 | 133 | 300 | SiH₄:15 H₂:2000 PH₃:3 |
| Photoelectric Conversion Layer | 200 | 80 | 400 | SiH₄:50 H₂:2000 |
| p-Type Layer | 160 | 133 | 240 | SiH₄:10 H₂:2000 B₂H₆:0.2 |

Referring to Table 8, the substrate temperature, the reaction pressure and the high-frequency power were set to 160°C, 133 Pa and 300 W respectively for forming the n-type layer 33 according to comparative example 2. Further, the flow rates of SiH₄ gas, H₂ gas and PH₃ gas were set to 15 sccm, 2000 sccm and 3 sccm respectively for forming the n-type layer 33.

Further, the substrate temperature, the reaction pressure and the high-frequency power were set to 200°C, 80 Pa and 400 W respectively for forming the photoelectric conversion layer 34. The flow rates of SiH₄ gas and H₂ gas were set to 50 sccm and 2000 sccm respectively for forming the photoelectric conversion layer 34.

In addition, the substrate temperature, the reaction pressure and the high-frequency power were set to 160°C, 133 Pa and 240 W respectively for forming the p-type layer 35. The flow rates of SiH₄ gas, H₂ gas and B₂H₆ gas were set to 10 sccm, 2000 sccm and 0.2 sccm respectively for forming the p-type layer 35.

Then, the intensity levels of X-ray diffraction peaks of the n-type layer 33, the photoelectric conversion layer 34 and the p-type layer 35 prepared under the conditions shown in Table 8 were measured respectively.

It has been proved that the n- and p-type layers 33 and 35 have substantially similar X-ray diffraction spectra, and the intensity levels of the (111) diffraction peaks of the n- and p-type layers 33 and 35 are higher than those of the (220) diffraction peaks in comparative example 2, as shown in Fig. 16. It has also been proved that the intensity level of the (111) diffraction peak of the photoelectric conversion layer 34 is also higher than that of the (220) diffraction peak. In other words, it has been possible to confirm that all of the n-type layer 33, the photoelectric conversion layer 34 and the p-type layer 35 have (111)-plane preferred crystal orientation according to comparative example 2.

Thus, it is conceivable that all of the surfaces of the n-type layer 33, the photoelectric conversion layer 34 and the p-type layer 35 were pyramidally irregularized according to comparative example 2 due to the aforementioned reason, as shown in Fig. 15. According to comparative example 2, the irregular surface of the photoelectric conversion layer 34 was conceivably rendered steeper than the irregular surface of the photoelectric conversion layer 14 according to Example 2 formed under the same condition since the photoelectric conversion layer 34 having the (111) preferred crystal orientation was formed on the n-type layer 33 having the (111) preferred crystal orientation. Further, the irregular surface of the p-type layer 35 was also conceivably rendered steeper than the irregular surface of the p-type layer 5 according to Example 1 formed under the same condition since the p-type layer 35 having the (111) preferred crystal orientation was formed on the photoelectric conversion layer 34 having the steep irregular surface.

Then, a front transparent electrode 36 of ITO having a thickness of 80 nm was formed on the p-type layer 35 by RF magnetron sputtering, similarly to the aforementioned Example 1. Further, collectors 37 of Ag having a thickness of 2 µm were formed on prescribed regions of the front transparent electrode 36 by vacuum evaporation. Thus, the photovoltaic apparatus according to comparative example 2 was prepared as shown in Fig. 15.

### (Common to Examples 1 to 6 and Comparative Examples 1 and 2)

### [Output Characteristic Measurement]

Output characteristics of the photovoltaic apparatuses prepared according to Examples 1 to 6 and comparative examples 1 and 2 in the aforementioned manners were measured under pseudo sunbeam application conditions of an optical spectrum of AM 1.5, light intensity of 100 mW/cm² and a measuring temperature of 25°C. The abbreviation AM stands for the term "air mass", which indicates the ratio of the path of a direct sunbeam incident upon the earth's atmosphere to the path of a sunbeam perpendicularly incident upon the atmosphere (standard atmosphere: 1013 hPa) of a standard state. Table 9 shows results of the measurement. Referring to Table 9, normalized conversion efficiencies and normalized short-circuit currents of Examples 1 to 6 and comparative example 2 are shown with reference to those of comparative example 1.

**Table 9**

| | Normalized Conversion Efficiency | Normalized Short-Circuit Current |
|---|---|---|
| Example 1 | 1. 03 | 1. 04 |
| Example 2 | 1. 02 | 1. 02 |
| Example 3 | 1. 04 | 1. 02 |
| Example 4 | 1. 02 | 1. 03 |
| Example 5 | 1. 01 | 1. 04 |
| Example 6 | 1.03 | 1. 01 |
| Comparative Example 1 | 1. 00 | 1. 00 |
| Comparative Example 2 | 0. 89 | 0. 92 |

Referring to Table 9, it has been proved that the photovoltaic apparatus according to Example 1 provided with the n- and p-type layers 3 and 5 having (111)-plane preferred crystal orientation and the photoelectric conversion layer 4 having (220)-plane orientation and the photovoltaic apparatus according to Example 2 provided with the n- and p-type layers 13 and 15 having (220)-plane orientation and the photoelectric conversion layer 14 having (111)-plane preferred crystal orientation exhibited conversion efficiencies and short-circuit currents higher than those of the photovoltaic apparatus according to comparative example 1 provided with the n-type layer 23, the photoelectric conversion layer 24 and the p-type layer 25 all having (220)-plane preferred crystal orientation. More specifically, the conversion efficiency and the short-circuit current of the photovoltaic apparatus according to Example 1 were 1.03 and 1.04 respectively with reference to those of the photovoltaic apparatus according to comparative example 1. On the other hand, the conversion efficiency and the short-circuit current of the photovoltaic apparatus according to Example 2 were 1.02 and 1.02 respectively with reference to those of the photovoltaic apparatus according to comparative example 1.

Conceivably from these results, it was possible to effectively absorb incident light with the photoelectric conversion layer 4 in the photovoltaic apparatus according to Example 1, capable of attaining an excellent optical confinement effect by scattering the incident light on both of the front side (the surface of the p-type layer 5) and the back side (the surface of the n-type layer 3). Further, it was also conceivably possible to efficiently absorb incident light with the photoelectric conversion layer 14 in the photovoltaic apparatus according to Example 2, capable of attaining an excellent optical confinement effect by scattering the incident light on the front side (the surface of the photoelectric conversion layer 14). In the photovoltaic apparatus according to comparative example 1, on the other hand, it was conceivably difficult to attain an excellent optical confinement on both of the front and back sides.

Comparing the photovoltaic apparatuses according to Examples 1 and 2 with each other, it has been proved that the conversion efficiency (1.03) and the short-circuit current (1.04) in the photovoltaic apparatus according to Example 1 are higher than the conversion efficiency (1.02) and the short-circuit current (1.02) in the photovoltaic apparatus according to Example 2. It is conceivable from these results that the conversion efficiency and the short-circuit current are more increased when forming the photovoltaic apparatus to be capable of attaining an excellent optical confinement effect on both of the front and back sides through irregular surfaces of n- and p-type layers, as compared with a case of constituting the photovoltaic apparatus to be capable of attaining an excellent optical confinement effect only on the front side through an irregular surface of only a photoelectric conversion layer. Further, the photoelectric conversion layer 4 (Example 1) formed to have (220)-plane preferred crystal orientation exhibited more excellent characteristics than the photoelectric conversion layer 14 (Example 2) formed to have (111)-plane preferred crystal orientation, and hence the conversion efficiency and the short-circuit current in the photovoltaic apparatus according to Example 1 were conceivably increased beyond those in the photovoltaic apparatus according to Example 2 also for this reason.

Referring to Table 9, it has also been proved that the conversion efficiencies and the short-circuit currents in the photovoltaic apparatuses according to Examples 3 to 6 including the n-type layers 43, 53, 63 and 73 and the p-type layers 45, 55, 65 and 75 having the preferred crystal orientation planes different from each other and the photoelectric conversion layers 44, 54, 64 and 74 having the preferred crystal orientation planes identical to those of either the n-type layers 43, 53, 63 and 73 or the p-type layers 45, 55, 65 and 75 are higher than those of the photovoltaic apparatus according to comparative example 1 provided with the n-type layer 23, the photoelectric conversion layer 24 and the p-type layer 25 all having (220)-plane preferred crystal orientation. More specifically, the conversion efficiency and the short-circuit current of the photovoltaic apparatus according to Example 3 provided with the n-type layer 43, the photoelectric conversion layer 44 and the p-type layer 45 having (111)-plane preferred crystal orientation, (220)-plane preferred crystal orientation and (220)-plane preferred crystal orientation respectively were 1.04 and 1.02 respectively. The conversion efficiency and the short-circuit current of the photovoltaic apparatus according to Example 4 provided with the n-type layer 53, the photoelectric conversion layer 54 and the p-type layer 55 having (111)-plane preferred crystal orientation, (111)-plane preferred crystal orientation and (220)-plane preferred crystal orientation respectively were 1.02 and 1.03 respectively. Further, the conversion efficiency and the short-circuit current of the photovoltaic apparatus according to Example 5 provided with the n-type layer 63, the photoelectric conversion layer 64 and the p-type layer 65 having (220)-plane preferred crystal orientation, (111)-plane preferred crystal orientation and (111)-plane preferred crystal orientation respectively were 1.01 and 1.04 respectively. In addition, the conversion efficiency and the short-circuit current of the photovoltaic apparatus according to Example 6 provided with the n-type layer 73, the photoelectric conversion layer 74 and the p-type layer 75 having (220)-plane preferred crystal orientation, (220)-plane preferred crystal orientation and (111)-plane preferred crystal orientation respectively were 1.03 and 1.01 respectively.

Conceivably from these results, it was possible to efficiently absorb incident light with the photoelectric conversion layer 44 in the photovoltaic apparatus according to Example 3, capable of attaining an excellent optical confinement effect by scattering the incident light on the back side (the surface of the n-type layer 43). It was also conceivably possible to efficiently absorb incident light with the photoelectric conversion layer 54 in the photovoltaic apparatus according to Example 4, capable of attaining an excellent optical confinement effect on both of the front side (the surface of the photoelectric conversion layer 54) and the back side (the surface of the n-type layer 53). Further, it was conceivably possible to efficiently absorb incident light with the photoelectric conversion layer 64 in the photovoltaic apparatus according to Example 5, capable of attaining an excellent optical confinement effect on the front side (the surfaces of the photoelectric conversion layer 64 and the p-type layer 65). In addition, it was also conceivably possible to efficiently absorb incident light with the photoelectric conversion layer 74 in the photovoltaic apparatus according to Example 6, capable of attaining an excellent optical confinement effect on the front side (the surface of the p-type layer 75). In the photovoltaic apparatus according to comparative example 1, on the other hand, it was conceivably difficult to attain an excellent optical confinement effect on the front and back sides, as hereinabove described.

Comparing the photovoltaic apparatuses according to Examples 3 to 6 with each other, it has been proved that the short-circuit current, conceivably remarkably influenced by optical confinement, is higher in the photovoltaic apparatus according to Example 5 exhibiting the short circuit current of 1.04 than those of the photovoltaic apparatuses according to the remaining Examples 3, 4 and 6 exhibiting short-circuit currents of 1.02, 1.03 and 1.01 respectively. Thus, it was conceivably possible to more efficiently perform optical confinement in the photovoltaic apparatus according to Example 5 scattering incident light through the surfaces of the photoelectric conversion layer 64 and the p-type layer 65 as compared with the photovoltaic apparatuses according to the remaining Examples 3, 4 and 6.

Comparing the photovoltaic apparatuses according to Examples 3 to 6 with each other, it has also been proved that the conversion efficiency of 1.04 in the photovoltaic apparatus according to Example 3 is higher than those of 1.02, 1.01 and 1.03 in the photovoltaic apparatuses according to the remaining Examples 4, 5 and 6 respectively.

It has further been proved that the conversion efficiency and the short-circuit current in the photovoltaic apparatus according to comparative example 2 provided with the n-type layer 33, the photoelectric conversion layer 34 and the p-type layer 35 all having (111)-plane preferred crystal orientation are lower than those in the photovoltaic apparatuses according to Examples 1 to 6 and comparative example 1. More specifically, the conversion efficiency and the short-circuit current in the photovoltaic apparatus according to comparative example 2 were 0.89 and 0.92 respectively with reference to those in the photovoltaic apparatus according to comparative example 2. It is conceivable from these results that the number of defects in the photoelectric conversion layer 34 was increased due to the deposition conditions of photoelectric conversion layer 34 on the n-type layer 33 having a irregular surface, which causes the excessively steep irregular surface of the photoelectric conversion layer 34 in the photovoltaic apparatus according to comparative example 2.

According to Example 1, as hereinabove described, the photoelectric conversion layer 4 is formed to have (220)-plane preferred crystal orientation easily providing a substantially flat surface while the n- and p-type layers 3 and 5 are formed to have (111)-plane preferred crystal orientation easily providing irregular surfaces, so that the surface of the p-type layer 5 formed on the photoelectric conversion layer 4 as well as the surface of the n-type layer 3 formed under the photoelectric conversion layer 4 can be irregularized also when the surface of the photoelectric conversion layer 4 approaches a substantially flat shape. Thus, the incident light can be scattered through the irregular surfaces of the n- and p-type layers 3 and 5, whereby an excellent optical confinement effect can be attained by light scattering on both of the front side (the surface of the p-type layer 5) and the back side (the surface of the n-type layer 3). Consequently, the photoelectric conversion layer 4 can more efficiently absorb the incident light, whereby the output characteristics of the photovoltaic apparatus can be improved.

According to Example 1, further, the photoelectric conversion layer 4 is so formed to have (220)-plane preferred crystal orientation that the output characteristics of the photovoltaic apparatus can be further improved since the photoelectric conversion layer 4 formed to have (220)-plane preferred crystal orientation has particularly excellent characteristics.

According to Example 2, as hereinabove described, the n- and p-type layers 13 and 15 are formed to have (220)-plane preferred crystal orientation easily providing substantially flat surfaces while the photoelectric conversion layer 14 is formed to have (111)-plane preferred crystal orientation easily providing an irregular surface so that the surface of the photoelectric conversion layer 14 formed on the n-type layer 13 can be irregularized also when the surface of the n-type layer 13 approaches a substantially flat shape. Thus, the incident light can be scattered through the irregular surface of the photoelectric conversion layer 14. In this case, an excellent optical confinement effect can be attained by light scattering on the front side (the surface of the photoelectric conversion layer 14), whereby the output characteristics of the photovoltaic apparatus can be improved. However, the output characteristics of the photovoltaic apparatus according to Example 2 are inferior to those of the photovoltaic apparatus according to the aforementioned Example 1 capable of attaining an excellent optical confinement effect due to the light scattering on both of the front and back sides.

According to Example 3, as hereinabove described, the photoelectric conversion layer 44 and the p-type layer 45 are formed to have (220)-plane preferred crystal orientation easily providing substantially flat surfaces while the n-type layer 43 is formed to have (111)-plane preferred crystal orientation easily providing an irregular surface so that the surface of the n-type layer 43 can be irregularized also when the surfaces of the photoelectric conversion layer 44 and the p-type layer 45 approach substantially flat shapes. Thus, the incident light can be scattered through the irregular surface of the n-type layer 43, whereby an excellent optical confinement effect can be attained by light scattering on the back side (the surface of the n-type layer 43). Consequently, the photoelectric conversion layer 44 can efficiently absorb the incident light, whereby the output characteristics of the photovoltaic apparatus can be improved.

According to Example 4, as hereinabove described, the p-type layer 55 is formed to have (220)-plane preferred crystal orientation easily providing a substantially flat surface while the n-type layer 53 and the photoelectric conversion layer 54 are formed to have (111)-plane preferred crystal orientation easily providing irregular surfaces so that the surfaces of the n-type layer 53 and the photoelectric conversion layer 54 can be irregularized also when the surface of the p-type layer 55 approaches a substantially flat shape. Thus, the incident light can be scattered through the irregular surfaces of the n-type layer 53 and the photoelectric conversion layer 54, whereby an excellent optical confinement effect can be attained by light scattering on both of the front side (the surface of the photoelectric conversion layer 54) and the back side (the surface of the n-type layer 53). Consequently, the photoelectric conversion layer 54 can efficiently absorb the incident light, whereby the output characteristics of the photovoltaic apparatus can be improved.

According to Example 5, as hereinabove described, the n-type layer 63 is formed to have (220)-plane preferred crystal orientation easily providing a substantially flat surface while the photoelectric conversion layer 64 and the p-type layer 65 are formed to have (111)-plane preferred crystal orientation easily providing irregular surfaces so that the surfaces of the photoelectric conversion layer 64 and the p-type layer 65 can be irregularized also when the surface of the n-type layer 63 approaches a substantially flat shape. Thus, the incident light can be scattered through the irregular surfaces of the photoelectric conversion layer 64 and the p-type layer 65, whereby an excellent optical confinement effect can be attained by light scattering on the front side (the surfaces of the photoelectric conversion layer 64 and the p-type layer 65). Consequently, the photoelectric conversion layer 64 can efficiently absorb the incident light, whereby the output characteristics of the photovoltaic apparatus can be improved.

According to Example 6, as hereinabove described, the n-type layer 73 and the photoelectric conversion layer 74 are formed to have (220)-plane preferred crystal orientation easily providing substantially flat surfaces while the p-type layer 75 is formed to have (111)-plane preferred crystal orientation easily providing an irregular surface so that the surface of the p-type layer 75 can be irregularized also when the surfaces of the n-type layer 73 and the photoelectric conversion layer 74 approach substantially flat shapes. Thus, the incident light can be scattered through the irregular surface of the p-type layer 75, whereby an excellent optical confinement effect can be attained by light scattering on the front side (the surface of the p-type layer 75). Consequently, the photoelectric conversion layer 74 can efficiently absorb the incident light, whereby the output characteristics of the photovoltaic apparatus can be improved.

According to Examples 3 and 6, the photoelectric conversion layers 44 and 74 are formed to have (220)-plane preferred crystal orientation so that the output characteristics of the photovoltaic apparatuses can be improved also by this since the photoelectric conversion layers 44 and 74 formed to have (220)-plane preferred crystal orientation have particularly excellent characteristics.

### (Example 7)

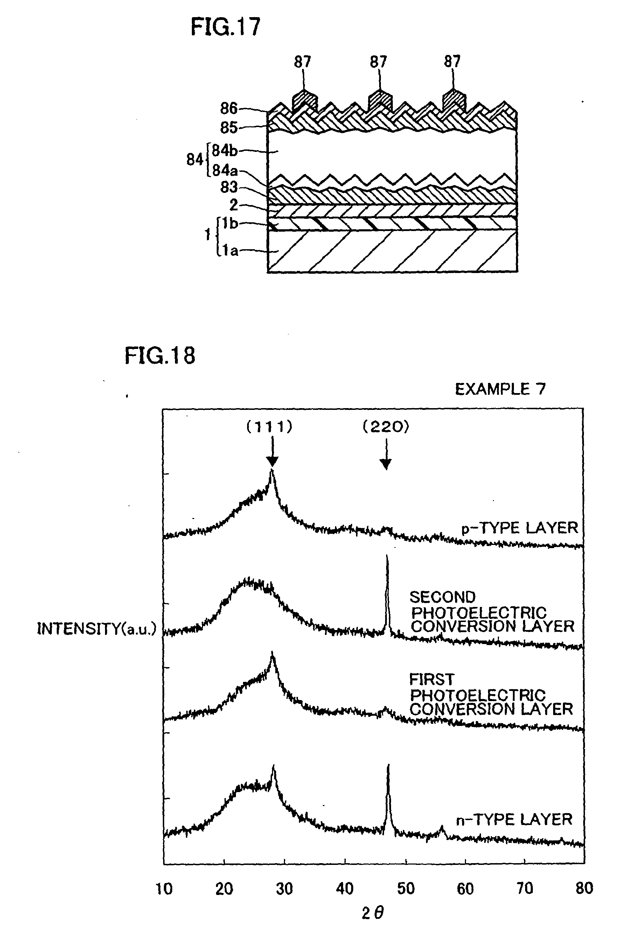

Referring to Fig. 17, a photoelectric conversion layer 84 of a photovoltaic apparatus according to Example 7 of the present invention has a two-layer structure, dissimilarly to the aforementioned Examples 1 to 6.

In the photovoltaic apparatus according to Example 7, a back electrode 2 is formed on a substrate 1 constituted of a stainless plate 1a and a polyimide resin layer 1b as shown in Fig. 17, similarly to the aforementioned Example 1. An n-type layer 83 consisting of an n-type microcrystalline silicon layer having a thickness of 50 nm is formed on the back electrode 2. The photoelectric conversion layer 84 consisting of a non-doped microcrystalline silicon layer having a thickness of 2 µm is formed on the n-type layer 83. A p-type layer 85 consisting of a p-type microcrystalline silicon layer having a thickness of 20 nm is formed on the photoelectric conversion layer 84. The n-type layer 83, the photoelectric conversion layer 84 and the p-type layer 85 constitute a power generation unit. The n-type layer 83, the photoelectric conversion layer 84 and the p-type layer 85 are examples of the "first non-single-crystalline semiconductor layer", the "second non-single-crystalline semiconductor layer" and the "third non-single-crystalline semiconductor layer" in the present invention respectively.

According to Example 7, the photoelectric conversion layer 84 is constituted of a first photoelectric conversion layer 84a having a thickness of 100 nm (0.1 µm) formed on the n-type layer 83 and a second photoelectric conversion layer 84b having a thickness of 1.9 µm formed on the first photoelectric conversion layer 84a. The first and second photoelectric conversion layers 84a and 84b have preferred crystal orientation planes different from each other. The n-type layer 83 has the same preferred crystal orientation plane as the second photoelectric conversion layer 84b, while the p-type layer 85 has the same preferred crystal orientation plane as the first photoelectric conversion layer 84a. The first and second photoelectric conversion layers 84a and 84b are examples of the "first layer" and the "second layer" in the present invention respectively.

A front transparent electrode 86 of ITO having a thickness of 80 nm is formed on the p-type layer 85. Collectors 87 of Ag having a thickness of 2 µm are formed on prescribed regions of the front transparent electrode 86.

A process of actually preparing the photovoltaic apparatus according to the aforementioned Example 7 is now described.

### [Preparation of Photovoltaic Apparatus]

First, the back electrode 2 was formed on the substrate 1 constituted of the stainless plate 1a and the polyimide resin 1b as shown in Fig. 17, similarly to the aforementioned Example 1.

Then, the microcrystalline semiconductor layers constituting the power generation unit were successively formed on the back electrode 2 by CVD, similarly to the aforementioned Example 1. More specifically, the n-type layer 83 consisting of the n-type microcrystalline silicon layer, the photoelectric conversion layer 84 consisting of the non-doped microcrystalline silicon layer and the p-type layer 85 consisting of the p-type microcrystalline silicon layer were successively formed. The photoelectric conversion layer 84 was formed by successively forming the first and second photoelectric conversion layers 84a and 84b. The n-type layer 83, the first photoelectric conversion layer 84a, the second photoelectric conversion layer 84b and the p-type layer 85 were formed to have the thicknesses of 50 nm, 100 nm, 1.9 µm and 20 nm respectively.

According to Example 7, the photovoltaic apparatus was prepared under the conditions shown in Table 10, so that the n-type layer 83 and the second photoelectric conversion layer 84b have (220)-plane preferred crystal orientation while the first photoelectric conversion layer 84a and the p-type layer 85 have (111)-plane preferred crystal orientation:

**Table 10**

| | Substrate Temperature (°C) | Reaction Pressure (Pa) | High-Frequency Power (W) | Gas Flow Rate (sccm) |
|---|---|---|---|---|
| n-Type Layer | 160 | 133 | 100 | SiH₄:2 H₂:200 PH₃:0. 2 |
| First Photoelectric Conversion Layer | 200 | 133 | 30 | SiH₄:10 H₂:400 |
| Second Photoelectric Conversion Layer | 200 | 133 | 30 | SiH₄:20 H₂:400 |
| p-Type Layer | 160 | 133 | 240 | SiH₄:10 H₂:2000 B₂H₆:0.2 |

Referring to Table 10, the substrate temperature, the reaction pressure and the high-frequency power were set to 160°C, 133 Pa and 100 W respectively for forming the n-type layer 83 according to Example 7. Further, the flow rates of SiH₄ gas, H₂ gas and PH₃ gas were set to 2 sccm, 200 sccm and 0.2 sccm respectively for forming the n-type layer 83.

The substrate temperature, the reaction pressure and the high-frequency power were set to 200°C, 133 Pa and 30 W respectively for forming the first photoelectric conversion layer 84a. The flow rates of SiH₄ gas and H₂ gas were set to 10 sccm and 400 sccm respectively for forming the first photoelectric conversion layer 84a.

Further, the substrate temperature, the reaction pressure and the high-frequency power were set to 200°C, 133 Pa and 30 W respectively for forming the second photoelectric conversion layer 84b. The flow rates of SiH₄ gas and H₂ gas were set to 20 sccm and 400 sccm respectively for forming the second photoelectric conversion layer 84b.

In addition, the substrate temperature, the reaction pressure and the high-frequency power were set to 160°C, 133 Pa and 240 W respectively for forming the p-type layer 85. The flow rates of SiH₄ gas, H₂ gas and B₂H₆ gas were set to 10 sccm, 2000 sccm and 0.2 sccm respectively for forming the p-type layer 85.

Then, the intensity levels of X-ray diffraction peaks of the n-type layer 83, the first photoelectric conversion layer 84a, the second photoelectric conversion layer 84b and the p-type layer 85 prepared under the conditions shown in Table 10 were measured respectively.

Referring to Fig. 18, it has been proved that the intensity levels of the (220) diffraction peaks of the n-type layer 83 and the second photoelectric conversion layer 84b are higher than those of the (111) diffraction peaks according to Example 7. It has also been proved that the intensity levels of the (111) diffraction peaks of the first photoelectric conversion layer 84a and the p-type layer 85 are higher than those of the (220) diffraction peaks. In other words, it has been possible to confirm that the n-type layer 83 and the second photoelectric conversion layer 84b have (220)-plane preferred crystal orientation while the first photoelectric conversion layer 84a and the p-type layer 85 have (111)-plane preferred crystal orientation. Thus, it is conceivable that the surfaces of the n-type layer 83 and the second photoelectric conversion layer 84b were loosely irregularized to approach substantially flat surfaces while the surfaces of the first photoelectric conversion layer 84a and the p-type layer 85 were pyramidally irregularized according to Example 7 due to the aforementioned reason, as shown in Fig. 17.

Then, the front transparent electrode 86 of ITO having the thickness of 80 nm was formed on the p-type layer 85 by RF magnetron sputtering, similarly to the aforementioned Example 1. Further, the collectors 87 of Ag having the thickness of 2 µm were formed on the prescribed regions of the front transparent electrode 86 by vacuum evaporation. Thus, the photovoltaic apparatus according to Example 7 was prepared as shown in Fig. 17.

### [Output Characteristic Measurement]

Output characteristics of the photovoltaic apparatus prepared according to Example 7 in the aforementioned manner were measured similarly to those of the photovoltaic apparatuses according to the aforementioned Examples 1 to 6 and the aforementioned comparative examples 1 and 2. In other words, the output characteristics were measured under pseudo sunbeam application conditions of an optical spectrum of AM 1.5, light intensity of 100 mW/cm² and a measuring temperature of 25°C. Table 11 shows results of the measurement. Referring to Table 11, a standard conversion efficiency and a standard short-circuit current are shown with reference to those of comparative example 1.

**Table 11**

| | Normalized Conversion Efficiency | Normalized Short-Circuit Current |
|---|---|---|
| Example 7 | 1. 04 | 1. 03 |

Referring to Tables 9 and 11, it has been proved that the conversion efficiency and the short-circuit current in the photovoltaic apparatus according to Example 7 including the photoelectric conversion layer 84 of the two-layer structure consisting of the first photoelectric conversion layer 84a having (111)-plane preferred crystal orientation and the second photoelectric conversion layer 84b having (220)-plane preferred crystal orientation, the n-type layer 83 having (220)-plane preferred crystal orientation and the p-type layer 85 having (111)-plane preferred crystal orientation are higher than those of the photovoltaic apparatus according to comparative example 1 including the photoelectric conversion layer 24 of a single-layer structure with the n-type layer 23, the photoelectric conversion layer 24 and the p-type layer 25 all having (220)-plane preferred crystal orientation. More specifically, the conversion efficiency and the short-circuit current in the photovoltaic apparatus according to Example 7 were 1.04 and 1.03 respectively with reference to those of the photovoltaic apparatus according to Example 1.

Conceivably from these results, it was possible to effectively absorb incident light with the photoelectric conversion layer 84 in the photovoltaic apparatus according to Example 7, capable of attaining an excellent optical confinement effect by scattering incident light on the front side (the surface of the p-type layer 85) and in the photoelectric conversion layer 84 (the surface of the first photoelectric conversion layer 84a). In the photovoltaic apparatus according to comparative example 1, on the other hand, it was conceivably difficult to attain an excellent optical confinement effect on the front and back sides and in the photoelectric conversion layer 24.

It has also been proved that the conversion efficiency (0.89) and the short-circuit current (0.92) in the photovoltaic apparatus according to comparative example 2 provided with the n-type layer 33, the photoelectric conversion layer 34 and the p-type layer 35 all having (111)-plane preferred crystal orientation were lower than those in the photovoltaic apparatus according to Example 7. Thus, it was conceivably possible to inhibit the photoelectric conversion layer 84 from formation of a large number of defects in the photovoltaic apparatus according to Example 7, dissimilarly to the photovoltaic apparatus according to comparative example 2.

According to Example 7, as hereinabove described, the n-type layer 83 is formed to have (220)-plane preferred crystal orientation easily providing a substantially flat surface while the p-type layer 85 is formed to have (111)-plane preferred crystal orientation easily providing an irregular surface so that the surface of the p-type layer 85 can be irregularized also when the surface of the n-type layer 83 approaches a substantially flat shape. According to Example 7, further, the photoelectric conversion layer 84 is provided in the two-layer structure consisting of the first and second photoelectric conversion layers 84a and 84b while the first photoelectric conversion layer 84a is formed to have (111)-plane preferred crystal orientation easily providing an irregular surface and the second photoelectric conversion layer 84b is formed to have (220)-plane preferred crystal orientation easily providing a substantially flat surface respectively, whereby the surface of the first photoelectric conversion layer 84a can be irregularized also when the surface of the second photoelectric conversion layer 84b approaches a substantially flat shape. Thus, the incident light can be scattered also through the irregular surface of the first photoelectric conversion layer 84a in addition to the irregular surface of the p-type layer 85, whereby an excellent optical confinement effect can be attained by light scattering on the front side (the surface of the p-type layer 85) and in the photoelectric conversion layer 84 (the surface of the first photoelectric conversion layer 84a). Consequently, the photoelectric conversion layer 84 can efficiently absorb the incident light, whereby the output characteristics of the photovoltaic apparatus can be improved.

According to Example 7, further, the second photoelectric conversion layer 84b consisting of a non-doped microcrystalline silicon layer having (220)-plane preferred crystal orientation is so formed on the first photoelectric conversion layer 84a consisting of a non-doped microcrystalline silicon layer having (111)-plane preferred crystal orientation that the second photoelectric conversion layer 84b can be crystal-grown from starting points (nuclei) of extremely fine microcrystalline grains formed with a proper density in the first photoelectric conversion layer 84a. It is known that some growth starting points triggering crystal growth are necessary for growing a non-single-crystalline semiconductor layer. According to Example 7, the second photoelectric conversion layer 84b is crystal-grown from the starting points of extremely fine microcrystalline grains formed with the proper density in the first photoelectric conversion layer 84a, whereby the quality of the second photoelectric conversion layer 84b can be improved. In this case, it is conceivable that the quality of the second photoelectric conversion layer 84b having an excellent photoelectric conversion property due to (220)-plane preferred crystal orientation and occupying most part (1.9 µm) of the photoelectric conversion layer 84 having the thickness of 2.0 µm is so improved that the photoelectric conversion property of the second photoelectric conversion layer 84b can be further improved. Consequently, the efficiency for extracting carriers formed by the photoelectric conversion layer 84 including the second photoelectric conversion layer 84b can be improved.

Although the present invention has been described and illustrated in detail, it is clearly understood that the same is by way of illustration and example only and is not to be taken by way of limitation, the scope of the present invention being limited only by the terms of the appended claims.

For example, while each of the photovoltaic apparatuses according to the aforementioned Examples 1 to 7 has the single power generation unit, the present invention is not restricted to this but at least one power generation unit may be identical to that in each of the photovoltaic apparatuses according to Examples 1 to 7 in the so-called stacked photovoltaic apparatus prepared by stacking a plurality of power generation units with each other. Thus, an excellent optical confinement effect can be attained in at least one power generation unit, whereby the output characteristics of the photovoltaic apparatus can be improved.

While the substrate 1 is constituted of the stainless plate 1a and the polyimide resin layer 1b formed thereon in each of the photovoltaic apparatuses according to the aforementioned Examples 1 to 7, the present invention is not restricted to this but the stainless plate 1a may alternatively be replaced with a plate of a metal such as iron, molybdenum or aluminum or an alloy material thereof. Further, the polyimide resin layer 1b may be replaced with a layer of an insulating material such as polyethersulfone (PES) resin or SiO₂. The aforementioned metals and insulating materials may be combined with each other in any manner.

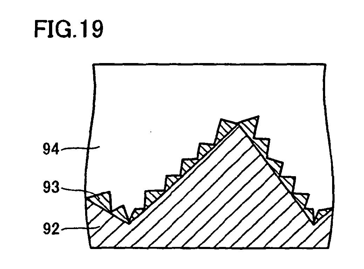

While the n-type layer 3 is formed on the flat back electrode 2 to have (111)-plane preferred crystal orientation easily providing an irregular surface in the photovoltaic apparatus according to the aforementioned Example 1, the present invention is not restricted to this but an n-type layer 93 may alternatively be formed on a back electrode 92 having a coarse irregular surface to have (111)-plane preferred crystal orientation easily providing an irregular surface, as shown in Fig. 19. In this case, incident light can be scattered through both of the coarse irregular surface of the back electrode 92 and the fine irregular surface of the n-type layer 93 on the back side, whereby a superior optical confinement effect can be attained as compared with the photovoltaic apparatus according to Example 1 (see Fig. 1) scattering the incident light only through the irregular surface of the n-type layer 3. Further, a photoelectric conversion layer 94 is formed on the n-type layer 93 to have (220)-plane preferred crystal orientation. The back electrode 92, the n-type layer 93 and the photoelectric conversion layer 94 are examples of the "underlayer", the "first non-single-crystalline semiconductor layer" and the "second non-single-crystalline semiconductor layer" in the present invention respectively.

The surface of the back electrode 92 formed on a substrate may be irregularized by irregularizing the surface of a polyimide resin layer constituting the substrate. The surface of the polyimide resin layer constituting the substrate may be irregularized by mixing particles of SiO₂ or TiO₂ having diameters of several 100 µm into the polyimide resin layer, for example.

While the n-type layer 43, 53, 63 or 73, the photoelectric conversion layer 44, 54, 64 or 74 and the p-type layer 45, 55, 65 or 75 have single-layer structures consisting of single layers in each of the photovoltaic apparatuses according to the aforementioned Examples 3 to 6, the present invention is not restricted to this but at least one of the n-type layer 43, 53, 63 or 73, the photoelectric conversion layer 44, 54, 64 or 74 and the p-type layer 45, 55, 65 or 75 may have a multilayer structure of at least two layers. In this case, at least one of layers constituting the n-type layer 43, 53, 63 or 73, the photoelectric conversion layer 44, 54, 64 or 74 and the p-type layer 45, 55, 65 or 75 may have a preferred crystal orientation plane different from those of the remaining layers.

## Claims

1. A photovoltaic apparatus including at least one power generation unit having a first conductivity type first non-single-crystalline semiconductor layer (3, 13, 43, 53, 63, 73, 83) including at least one layer, a substantially intrinsic second non-single-crystalline semiconductor layer (4, 14, 44, 54, 64, 74, 84), formed on said first non-single-crystalline semiconductor layer, including at least one layer and functioning as a photoelectric conversion layer, and a second conductivity type third non-single-crystalline semiconductor layer (5, 15, 45, 55, 65, 75, 85), formed on said second non-single-crystalline semiconductor layer, including at least one layer, wherein
at least one of said layer constituting said first non-single-crystalline semiconductor layer, said layer constituting said second non-single-crystalline semiconductor layer and said layer constituting said third non-single crystalline semiconductor layer has a preferred crystal orientation plane different from the preferred crystal orientation planes of remaining said layers.

2. The photovoltaic apparatus according to claim 1, wherein
said layers constituting said first and third non-single-crystalline semiconductor layers respectively and said layer constituting said second non-single crystalline semiconductor layer have preferred crystal orientation planes different from each other.

3. The photovoltaic apparatus according to claim 2, wherein
said first non-single-crystalline semiconductor layer, said second non-single-crystalline semiconductor layer and said third non-single crystalline semiconductor layer include non-single-crystalline silicon layers, and
either said layers constituting said first and third non-single-crystalline semiconductor layers respectively or said layer constituting said second non-single crystalline semiconductor layer have (111)-plane preferred crystal orientation and the other one of said layers constituting said first and third non-single-crystalline semiconductor layers respectively and said layer constituting said second non-single crystalline semiconductor layer have (220)-plane preferred crystal orientation.

4. The photovoltaic apparatus according to claim 3, wherein
said layer (4) constituting said second non-single crystalline semiconductor layer has said (220)-plane preferred crystal orientation and said layers (3, 5) constituting said first and third non-single-crystalline semiconductor layers respectively have said (111)-plane preferred crystal orientation.

5. The photovoltaic apparatus according to claim 3, wherein
said layer (14) constituting said second non-single crystalline semiconductor layer has said (111)-plane preferred crystal orientation and said layers (13, 15) constituting said first and third non-single-crystalline semiconductor layers respectively have said (220)-plane preferred crystal orientation.

6. The photovoltaic apparatus according to claim 1, wherein
either said layer constituting said first non-single crystalline semiconductor layer or said layer constituting said third non-single-crystalline semiconductor layer has the same preferred crystal orientation plane as said layer constituting said second non-single-crystalline semiconductor layer and the other one of said layers constituting said first and third non-single crystalline semiconductor layers respectively has a preferred crystal orientation plane different from the preferred crystal orientation plane of said layer constituting said second non-single-crystalline semiconductor layer.

7. The photovoltaic apparatus according to claim 6, wherein
said first non-single-crystalline semiconductor layer, said second non-single-crystalline semiconductor layer and said third non-single-crystalline semiconductor layer include non-single-crystalline silicon layers, and
said layer (43) constituting said first non-single-crystalline semiconductor layer has (111)-plane preferred crystal orientation, and said layers (44, 45) constituting said second and third non-single-crystalline semiconductor layers respectively have (220)-plane preferred crystal orientation.

8. The photovoltaic apparatus according to claim 6, wherein
said first non-single-crystalline semiconductor layer, said second non-single-crystalline semiconductor layer and said third non-single-crystalline semiconductor layer include non-single-crystalline silicon layers, and
said layers (53, 54) constituting said first and second non-single-crystalline semiconductor layers respectively have (111)-plane preferred crystal orientation, and said layer (55) constituting said third non-single-crystalline semiconductor layer has (220)-plane preferred crystal orientation.

9. The photovoltaic apparatus according to claim 6, wherein
said first non-single-crystalline semiconductor layer, said second non-single-crystalline semiconductor layer and said third non-single-crystalline semiconductor layer include non-single-crystalline silicon layers, and
said layer (63) constituting said first non-single-crystalline semiconductor layer has (220)-plane preferred crystal orientation, and said layers (64, 65) constituting said second and third non-single-crystalline semiconductor layers respectively have (111)-plane preferred crystal orientation.

10. The photovoltaic apparatus according to claim 6, wherein
said first non-single-crystalline semiconductor layer, said second non-single-crystalline semiconductor layer and said third non-single-crystalline semiconductor layer include non-single-crystalline silicon layers, and
said layers (73, 74) constituting said first and second non-single-crystalline semiconductor layers respectively have (220)-plane preferred crystal orientation, and said layer (75) constituting said third non-single-crystalline semiconductor layer has (111)-plane preferred crystal orientation.

11. The photovoltaic apparatus according to claim 1, wherein
at least one of said first non-single-crystalline semiconductor layer, said second non-single-crystalline semiconductor layer and said third non-single-crystalline semiconductor layer includes a plurality of layers, and
at least one of said plurality of layers has a preferred crystal orientation plane different from the preferred crystal orientation plane of remaining said layers.

12. The photovoltaic apparatus according to claim 11, wherein
said second non-single-crystalline semiconductor layer (84) includes a first layer (84a) and a second layer (84b), and
said first layer and said second layer have preferred crystal orientation planes different from each other.

13. The photovoltaic apparatus according to claim 12, wherein
said second non-single-crystalline semiconductor layer includes a non-single-crystalline silicon layer, and
said first layer has (111)-plane preferred crystal orientation, and said second layer is formed on said first layer and has (220)-plane preferred crystal orientation.

14. The photovoltaic apparatus according to claim 13, wherein
said first non-single-crystalline semiconductor layer and said third non-single-crystalline semiconductor layer include non-single-crystalline silicon layers, and
said layer constituting said first non-single-crystalline semiconductor layer has (220)-plane preferred crystal orientation, and said layer constituting said third non-single-crystalline semiconductor layer has (111)-plane preferred crystal orientation.

15. The photovoltaic apparatus according to claim 1, wherein
at least one of said layer constituting said first non-single-crystalline semiconductor layer, said layer constituting said second non-single-crystalline semiconductor layer and said layer constituting said third non-single crystalline semiconductor layer has an irregular surface.

16. The photovoltaic apparatus according to claim 15, wherein
said layer (3) constituting said first non-single-crystalline semiconductor layer and said layer (5) constituting said third non-single crystalline semiconductor layer have said irregular surfaces.

17. The photovoltaic apparatus according to claim 15, wherein
said layer (53) constituting said first non-single-crystalline semiconductor layer and said layer (55) constituting said second non-single crystalline semiconductor layer have said irregular surfaces.

18. The photovoltaic apparatus according to claim 15, wherein
said layer (64) constituting said second non-single-crystalline semiconductor layer and said layer (65) constituting said third non-single crystalline semiconductor layer have said irregular surfaces.

19. The photovoltaic apparatus according to claim 15, wherein
said layer having said irregular surface includes a non-single-crystalline silicon layer having (111)-plane preferred crystal orientation.

20. The photovoltaic apparatus according to claim 1, further comprising an underlayer having an irregular surface, wherein
said first non-single-crystalline semiconductor layer has an irregular surface, and
said first non-single-crystalline semiconductor layer having said irregular surface is formed on said underlayer having said irregular surface.

21. The photovoltaic apparatus according to claim 1, wherein
said first non-single-crystalline semiconductor layer, said second non-single-crystalline semiconductor layer and said third non-single-crystalline semiconductor layer include microcrystalline semiconductor layers.

## Patentansprüche

1. Photovoltaikvorrichtung, umfassend zumindest eine Energieerzeugungseinheit mit einer ersten nicht-einkristallinen Halbleiterschicht (3, 13, 43, 53, 63, 73, 83) eines ersten Leitfähigkeitstyps, die zumindest eine Schicht umfasst, einer im Wesentlichen inhärenten zweiten nicht-einkristallinen Halbleiterschicht (4, 14, 44, 54, 64, 74, 84), die auf der ersten nicht-einkristallinen Halbleiterschicht ausgebildet ist, zumindest eine Schicht umfasst und als Schicht zur photoelektrischen Umwandlung fungiert, und einer dritten nicht-einkristallinen Halbleiterschicht eines zweiten Leitfähigkeitstyps (5, 15, 45, 55, 65, 75, 85), die auf der zweiten nicht-einkristallinen Halbleiterschicht ausgebildet ist und zumindest eine Schicht umfasst, worin
zumindest eine von der Schicht, die die erste nicht-einkristalline Halbleiterschicht bildet, der Schicht, die die zweite nicht-einkristalline Halbleiterschicht bildet und der Schicht, die die dritte nicht-einkristalline Halbleiterschicht bildet, eine bevorzugte Kristallorientierungsebene aufweist, die sich von den bevorzugten Kristallorientierungsebenen der übrigen Schichten unterscheidet.

2. Photovoltaikvorrichtung nach Anspruch 1, worin
die Schichten, die die erste bzw. die dritte nicht-einkristalline Halbleiterschicht bilden, und die Schicht, die die zweite nicht-einkristalline Halbleiterschicht bildet, jeweils unterschiedliche Kristallorientierungsebenen aufweisen.

3. Photovoltaikvorrichtung nach Anspruch 2, worin
die erste nicht-einkristalline Halbleiterschicht, die zweite nicht-einkristalline Halbleiterschicht und die dritte nicht-einkristalline Halbleiterschicht nicht-einkristalline Siliciumschichten umfassen und
entweder die Schichten, die die erste bzw. die dritte nicht-einkristalline Halbleiterschicht bilden, oder die Schicht, die die zweite nicht-einkristalline Halbleiterschicht bildet, bevorzugte (111)-Ebene-Kristallorientierung aufweisen bzw. aufweist und die jeweils andere von den Schichten, die die erste bzw. die dritte nicht-einkristalline Halbleiterschicht bilden, und der Schicht, die die zweite nicht-einkristalline Halbleiterschicht bildet, bevorzugte (220)-Ebene-Kristallorientierung aufweisen bzw. aufweist.

4. Photovoltaikvorrichtung nach Anspruch 3, worin
die Schicht (4), die die zweite nicht-einkristalline Halbleiterschicht bildet, die bevorzugte (220)-Ebene-Kristallorientierung aufweist und die Schichten (3, 5), die die erste bzw. die dritte nicht-einkristalline Halbleiterschicht bilden, die bevorzugte (111)-Ebene-Kristallorientierung aufweisen.

5. Photovoltaikvorrichtung nach Anspruch 3, worin
die Schicht (14), die die zweite nicht-einkristalline Halbleiterschicht bildet, die bevorzugte (111)-Ebene-Kristallorientierung aufweist und die Schichten (13, 15), die die erste bzw. die dritte nicht-einkristalline Halbleiterschicht bilden, die bevorzugte (220)-Ebene-Kristallorientierung aufweisen.

6. Photovoltaikvorrichtung nach Anspruch 1, worin
entweder die Schicht, die die erste nicht-einkristalline Halbleiterschicht bildet, oder die Schicht, die die dritte nicht-einkristalline Halbleiterschicht bildet, die gleiche bevorzugte Kristallorientierungsebene aufweist wie die Schicht, die die zweite nicht-einkristalline Halbleiterschicht bildet, und die andere von der Schicht, die die erste bzw. die dritte nicht-einkristalline Halbleiterschicht bildet, eine andere Kristallorientierungsebene aufweist als die Kristallorientierungsebene der Schicht, die die zweite nicht-einkristalline Halbleiterschicht bildet.

7. Photovoltaikvorrichtung nach Anspruch 6, worin
die erste nicht-einkristalline Halbleiterschicht, die zweite nicht-einkristalline Halbleiterschicht und die dritte nicht-einkristalline Halbleiterschicht nicht-einkristalline Siliciumschichten umfassen und
die Schicht (43), die die erste nicht-einkristalline Halbleiterschicht bildet, bevorzugte (111)-Ebene-Kristallorientierung aufweist und die Schichten (44, 45), die die zweite bzw. die dritte nicht-einkristalline Halbleiterschicht bilden, bevorzugte (220)-Ebene-Kristallorientierung aufweisen.

8. Photovoltaikvorrichtung nach Anspruch 6, worin
die erste nicht-einkristalline Halbleiterschicht, die zweite nicht-einkristalline Halbleiterschicht und die dritte nicht-einkristalline Halbleiterschicht nicht-einkristalline Siliciumschichten umfassen und
die Schichten (53, 54), die die erste bzw. die zweite nicht-einkristalline Halbleiterschicht bilden, bevorzugte (111)-Ebene-Kristallorientierung aufweisen und die Schicht (55), die die dritte nicht-einkristalline Halbleiterschicht bildet, bevorzugte (220)-Ebene-Kristallorientierung aufweist.

9. Photovoltaikvorrichtung nach Anspruch 6, worin
die erste nicht-einkristalline Halbleiterschicht, die zweite nicht-einkristalline Halbleiterschicht und die dritte nicht-einkristalline Halbleiterschicht nicht-einkristalline Siliciumschichten umfassen und
die Schicht (63), die die erste nicht-einkristalline Halbleiterschicht bildet, bevorzugte (220)-Ebene-Kristallorientierung aufweist und die Schichten (64, 65), die die zweite bzw. die dritte nicht-einkristalline Halbleiterschicht bilden, bevorzugte (111)-Ebene-Kristallorientierung aufweisen.

10. Photovoltaikvorrichtung nach Anspruch 6, worin
die erste nicht-einkristalline Halbleiterschicht, die zweite nicht-einkristalline Halbleiterschicht und die dritte nicht-einkristalline Halbleiterschicht nicht-einkristalline Siliciumschichten umfassen und
die Schichten (73, 74), die die erste bzw. die zweite nicht-einkristalline Halbleiterschicht bilden, bevorzugte (220)-Ebene-Kristallorientierung aufweisen und die Schicht (75), die die dritte nicht-einkristalline Halbleiterschicht bildet, bevorzugte (111)-Ebene-Kristallorientierung aufweist.

11. Photovoltaikvorrichtung nach Anspruch 1, worin
zumindest eine von der ersten nicht-einkristallinen Halbleiterschicht, der zweiten nicht-einkristallinen Halbleiterschicht und der dritten nicht-einkristallinen Halbleiterschicht eine Vielzahl von Schichten umfasst, und
zumindest eine aus der Vielzahl von Schichten eine bevorzugte Kristallorientierungsebene aufweist, die sich von den bevorzugten Kristallorientierungsebenen der übrigen Schichten unterscheidet.

12. Photovoltaikvorrichtung nach Anspruch 11, worin
die zweite nicht-einkristalline Halbleiterschicht (84) eine erste Schicht (84a) und eine zweite Schicht (84b) umfasst, und
die erste Schicht und die zweite Schicht unterschiedliche bevorzugte Kristallorientierungsebenen aufweisen.

13. Photovoltaikvorrichtung nach Anspruch 12, worin
die zweite nicht-einkristalline Halbleiterschicht eine nicht-einkristalline Siliciumschicht umfasst, und
die erste Schicht bevorzugte (111)-Ebene-Kristallorientierung aufweist und die zweite Schicht auf der ersten Schicht ausgebildet ist und bevorzugte (220)-Ebene-Kristallorientierung aufweist.

14. Photovoltaikvorrichtung nach Anspruch 13, worin
die erste nicht-einkristalline Halbleiterschicht und die dritte nicht-einkristalline Halbleiterschicht nicht-einkristalline Siliciumschichten umfassen und
die Schicht, die die erste nicht-einkristalline Halbleiterschicht bildet, bevorzugte (220)-Ebene-Kristallorientierung aufweist und die Schicht, die die dritte nicht-einkristalline Halbleiterschicht bildet, bevorzugte (111)-Ebene-Kristallorientierung aufweist.

15. Photovoltaikvorrichtung nach Anspruch 1, worin
zumindest eine von der Schicht, die die erste nicht-einkristalline Halbleiterschicht bildet, der Schicht, die die zweite nicht-einkristalline Halbleiterschicht bildet und der Schicht, die die dritte nicht-einkristalline Halbleiterschicht bildet, eine unregelmäßige Oberfläche aufweist.

16. Photovoltaikvorrichtung nach Anspruch 15, worin
die Schicht (3), die die erste nicht-einkristalline Halbleiterschicht bildet, und die Schicht (5), die die dritte nicht-einkristalline Halbleiterschicht bildet, unregelmäßige Oberflächen aufweisen.

17. Photovoltaikvorrichtung nach Anspruch 15, worin
die Schicht (53), die die erste nicht-einkristalline Halbleiterschicht bildet, und die Schicht (55), die die zweite nicht-einkristalline Halbleiterschicht bildet, unregelmäßige Oberflächen aufweisen.

18. Photovoltaikvorrichtung nach Anspruch 15, worin
die Schicht (64), die die zweite nicht-einkristalline Halbleiterschicht bildet, und die Schicht (65), die die dritte nicht-einkristalline Halbleiterschicht bildet, unregelmäßige Oberflächen aufweisen.

19. Photovoltaikvorrichtung nach Anspruch 15, worin
die Schicht mit der unregelmäßigen Oberfläche eine nicht-einkristalline Siliciumschicht mit bevorzugter (111)-Ebene-Kristallorientierung umfasst.

20. Photovoltaikvorrichtung nach Anspruch 1, weiters umfassend eine Unterschicht mit unregelmäßiger Oberfläche, worin
die erste nicht-einkristalline Halbleiterschicht eine unregelmäßige Oberfläche aufweist und
die erste nicht-einkristalline Halbleiterschicht mit der unregelmäßigen Oberfläche auf der Unterschicht mit der unregelmäßigen Oberfläche ausgebildet ist.

21. Photovoltaikvorrichtung nach Anspruch 1, worin
die erste nicht-einkristalline Halbleiterschicht, die zweite nicht-einkristalline Halbleiterschicht und die dritte nicht-einkristalline Halbleiterschicht mikrokristalline Halbleiterschichten umfassen.

## Revendications

1. Dispositif photovoltaïque comprenant au moins une unité de génération d'énergie comportant une première couche semi-conductrice non monocristalline (3, 13, 43, 53, 63, 73, 83) d'un premier type de conductivité comprenant au moins une couche, une deuxième couche semi-conductrice non monocristalline sensiblement intrinsèque (4, 14, 44, 54, 64, 74, 84), formée sur ladite première couche semi-conductrice non monocristalline, comprenant au moins une couche et fonctionnant en tant que couche de conversion photoélectrique, et une troisième couche semi-conductrice non monocristalline (5, 15, 45, 55, 65, 75, 85) d'un deuxième type de conductivité, formée sur ladite deuxième couche semi-conductrice non monocristalline, comprenant au moins une couche, dans lequel
au moins l'une de ladite couche constituant ladite première couche semi-conductrice non monocristalline, de ladite couche constituant ladite deuxième couche semi-conductrice non monocristalline et de ladite couche constituant ladite troisième couche semi-conductrice non monocristalline a un plan d'orientation cristalline préféré différent des plans d'orientation cristalline préférés desdites couches restantes.

2. Dispositif photovoltaïque selon la revendication 1, dans lequel
lesdites couches constituant lesdites première et troisième couches semi-conductrices non monocristallines respectivement et ladite couche constituant ladite deuxième couche semi-conductrice non monocristalline ont des plans d'orientation cristalline préférés différents l'un de l'autre.

3. Dispositif photovoltaïque selon la revendication 2, dans lequel
ladite première couche semi-conductrice non monocristalline, ladite deuxième couche semi-conductrice non monocristalline et ladite troisième couche semi-conductrice non monocristalline comprennent des couches de silicium non monocristallin, et
l'une ou l'autre desdites couches constituant lesdites première et troisième couches semi-conductrices non monocristallines respectivement ou ladite couche constituant ladite deuxième couche semi-conductrice non monocristalline ont une orientation cristalline préférée de plan (111) et l'autre desdites couches constituant lesdites première et troisième couches semi-conductrices non monocristallines respectivement et ladite couche constituant ladite deuxième couche semi-conductrice non monocristalline ont une orientation cristalline préférée de plan (220).

4. Dispositif photovoltaïque selon la revendication 3, dans lequel
ladite couche (4) constituant ladite deuxième couche semi-conductrice non monocristalline a ladite orientation cristalline préférée de plan (220) et lesdites couches (3, 5) constituant lesdites première et troisième couches semi-conductrices non monocristallines respectivement ont ladite orientation cristalline préférée de plan (111).

5. Dispositif photovoltaïque selon la revendication 3, dans lequel
ladite couche (14) constituant ladite deuxième couche semi-conductrice non monocristalline a ladite orientation cristalline préférée de plan (111) et lesdites couches (13, 15) constituant lesdites première et troisième couches semi-conductrices non monocristallines respectivement ont ladite orientation cristalline préférée de plan (220).

6. Dispositif photovoltaïque selon la revendication 1, dans lequel
soit ladite couche constituant ladite première couche semi-conductrice non monocristalline, soit ladite couche constituant ladite troisième couche semi-conductrice non monocristalline a le même plan d'orientation cristalline préféré que ladite couche constituant ladite deuxième couche semi-conductrice non monocristalline et l'autre desdites couches constituant lesdites première et troisième couches semi-conductrices non monocristallines respectivement a un plan d'orientation cristalline préféré différent du plan d'orientation cristalline préféré de ladite couche constituant ladite deuxième couche semi-conductrice non monocristalline.

7. Dispositif photovoltaïque selon la revendication 6, dans lequel
ladite première couche semi-conductrice non monocristalline, ladite deuxième couche semi-conductrice non monocristalline et ladite troisième couche semi-conductrice non monocristalline comprennent des couches de silicium non monocristallin, et
ladite couche (43) constituant ladite première couche semi-conductrice non monocristalline a une orientation cristalline préférée de plan (111), et lesdites couches (44, 45) constituant lesdites deuxième et troisième couches semi-conductrices non monocristallines respectivement ont une orientation cristalline préférée de plan (220).

8. Dispositif photovoltaïque selon la revendication 6, dans lequel
ladite première couche semi-conductrice non monocristalline, ladite deuxième couche semi-conductrice non monocristalline et ladite troisième couche semi-conductrice non monocristalline comprennent des couches de silicium non monocristallin, et
lesdites couches (53, 54) constituant lesdites première et deuxième couches semi-conductrices non monocristallines respectivement ont une orientation cristalline préférée de plan (111), et ladite couche (55) constituant ladite troisième couche semi-conductrice non monocristalline a une orientation cristalline préférée de plan (220).

9. Dispositif photovoltaïque selon la revendication 6, dans lequel
ladite première couche semi-conductrice non monocristalline, ladite deuxième couche semi-conductrice non monocristalline et ladite troisième couche semi-conductrice non monocristalline comprennent des couches de silicium non monocristallin, et
ladite couche (63) constituant ladite première couche semi-conductrice non monocristalline a une orientation cristalline préférée de plan (220), et lesdites couches (64, 65) constituant lesdites deuxième et troisième couches semi-conductrices non monocristallines respectivement ont une orientation cristalline préférée de plan (111).

10. Dispositif photovoltaïque selon la revendication 6, dans lequel
ladite première couche semi-conductrice non monocristalline, ladite deuxième couche semi-conductrice non monocristalline et ladite troisième couche semi-conductrice non monocristalline comprennent des couches de silicium non monocristallin, et
lesdites couches (73, 74) constituant lesdites première et deuxième couches semi-conductrices non monocristallines respectivement ont une orientation cristalline préférée de plan (220), et ladite couche (75) constituant ladite troisième couche semi-conductrice non monocristalline a une orientation cristalline préférée de plan (111).

11. Dispositif photovoltaïque selon la revendication 1, dans lequel
au moins l'une de ladite première couche semi-conductrice non monocristalline, de ladite deuxième couche semi-conductrice non monocristalline et de ladite troisième couche semi-conductrice non monocristalline comprend une pluralité de couches, et
au moins l'une de ladite pluralité de couches a un plan d'orientation cristalline préféré différent du plan d'orientation cristalline préféré desdites couches restantes.

12. Dispositif photovoltaïque selon la revendication 11, dans lequel
ladite deuxième couche semi-conductrice non monocristalline (84) comprend une première couche (84a) et une deuxième couche (84b), et
ladite première couche et ladite deuxième couche ont des plans d'orientation cristalline préférés différents l'un de l'autre.

13. Dispositif photovoltaïque selon la revendication 12, dans lequel
ladite deuxième couche semi-conductrice non monocristalline comprend une couche de silicium non monocristalline, et
ladite première couche a une orientation cristalline préférée de plan (111), et ladite deuxième couche est formée sur ladite première couche et a une orientation cristalline préférée de plan (220).

14. Dispositif photovoltaïque selon la revendication 13, dans lequel
ladite première couche semi-conductrice non monocristalline et ladite troisième couche semi-conductrice non monocristalline comprennent des couches de silicium non monocristallin, et
ladite couche constituant ladite première couche semi-conductrice non monocristalline a une orientation cristalline préférée de plan (220), et ladite couche constituant ladite troisième couche semi-conductrice non monocristalline a une orientation cristalline préférée de plan (111).

15. Dispositif photovoltaïque selon la revendication 1, dans lequel
au moins l'une de ladite couche constituant ladite première couche semi-conductrice non monocristalline, de ladite couche constituant ladite deuxième couche semi-conductrice non monocristalline et de ladite couche constituant ladite troisième couche semi-conductrice non monocristalline a une surface irrégulière.

16. Dispositif photovoltaïque selon la revendication 15, dans lequel
ladite couche (3) constituant ladite première couche semi-conductrice non monocristalline et ladite couche (5) constituant ladite troisième couche semi-conductrice non monocristalline ont lesdites surfaces irrégulières.

17. Dispositif photovoltaïque selon la revendication 15, dans lequel
ladite couche (53) constituant ladite première couche semi-conductrice non monocristalline et ladite couche (55) constituant ladite deuxième couche semi-conductrice non monocristalline ont lesdites surfaces irrégulières.

18. Dispositif photovoltaïque selon la revendication 15, dans lequel
ladite couche (64) constituant ladite deuxième couche semi-conductrice non monocristalline et ladite couche (65) constituant ladite troisième couche semi-conductrice non monocristalline ont lesdites surfaces irrégulières.

19. Dispositif photovoltaïque selon la revendication 15, dans lequel
ladite couche comportant ladite surface irrégulière comprend une couche de silicium non monocristallin ayant une orientation cristalline préférée de plan (111).

20. Dispositif photovoltaïque selon la revendication 1, comprenant en outre une sous-couche ayant une surface irrégulière, dans lequel
ladite première couche semi-conductrice non monocristalline a une surface irrégulière, et
ladite première couche semi-conductrice non monocristalline ayant ladite surface irrégulière est formée sur ladite sous-couche ayant ladite surface irrégulière.

21. Dispositif photovoltaïque selon la revendication 1, dans lequel
ladite première couche semi-conductrice non monocristalline, ladite deuxième couche semi-conductrice non monocristalline et ladite troisième couche semi-conductrice non monocristalline comprennent des couches semi-conductrices microcristallines.
